# EUROPEAN PATENT APPLICATION

(11) **EP 4 247 128 A1**
(43) Date of publication of application: **20.09.2023**
(21) Application number: 23161927.1
(22) Date of filing: 14.03.2023
(51) Int. Cl.: H05K 1/02, H05K 1/11, H05K 3/00, H05K 3/28, H05K 3/42

(54) **SHIELDED SIGNAL VIAS IN PRINTED CIRCUIT BOARDS FOR HIGH FREQUENCY AND BROADBAND SIGNALS**

(30) Priority: 14.03.2022 US 202263319704 P
(71) Applicant: TTM Technologies, Inc., Santa Ana, CA 92707 (US)
(72) Inventor: Kirkeby, Niels Husted, Santa Ana, 92707 (US)
(74) Representative: Greaves Brewster LLP

(57) **Abstract**

A printed circuit board (PCB) core structure (600A) is provided for the transition of signals from one side of a PCB to an opposing side of the PCB. The PCB core structure (600A) includes a laminated core including an inner core including a plurality of conductive layers (N layers) (607), a first dielectric layer, a first conductive trace (608) disposed over the Nth conductive layer on a first side of the laminated core. The PCB core structure (600A) also includes a signal via (602) extending from a first conductive layer to an Nth conductive layer through the laminated core, the signal via (602) configured to connect the first conductive trace (608) to a pin or a second conductive trace (610) on a second side of the laminated core. The PCB core structure (600A) also includes a shielding structure (604, 612) surrounding the signal via and partially extending from the first conductive layer to the Nth conductive layer. The PCB core structure (600A) also includes a cavity (618) removing a portion of the shielding structure in the Nth conductive layer and filled with a dielectric material. The cavity (618) filled with the dielectric material prevents the first conductive trace (608) from shorting to the shielding structure. The PCB core structure may be fabricated by using a single-lamination cycle.

## Description

### CROSS-REFERENCE TO RELATED PATENT APPLICATIONS

This patent application claims priority from U.S. Patent Application Serial No. 63/319,704 filed on March 14, 2022.

### FIELD

The disclosure is directed to the design and methods for forming a horizontal-to-vertical transition (H2V) or a horizontal-to-horizontal (H2H) transition of high-frequency and/or broadband signals from one side of a PCB to the other side of the PCB while maintaining controlled impedance and shielding.

### BACKGROUND

A common multilayer printed circuit board (PCB) is a double-sided board or substrate, where parts and components are attached to either side of the substrate. The PCB also referred to as interconnects, facilitates multiple signal connections and signal transitions from one metal layer to another metal layer and is used extensively in various electronic equipment.

The double-sided board or substrate includes laminates formed of sheets of cores and pre-preg, which are laminated together with heat and pressure, with sheets of copper foil on either side. Once the resin in the pre-preg hardens or in the case of thermal plastics, cools down, the double-sided board or substrate is a plastic composite with sheets of copper foil on both sides forming a new core.

Lamination is the process of building a multilayer printed circuit board (PCB). Layer materials may often go through two or more lamination cycles, each cycle adding to the cost, and vias may be formed at each cycle. The interconnections often dictate which lamination cycle needs to have vias formed, but sometimes it is instead dictated by limitations in forming these vias, it is, for example, very difficult to form a buried via without adding an extra lamination cycle. The vias are often designed to achieve the interconnects while reducing the number of lamination cycles for low-cost fabrication. There remains a need for developing new designs and methods for reducing fabrication costs.

### BRIEF SUMMARY

In one aspect, a PCB core structure is provided for the transition of signals from one side of a printed circuit board (PCB) to an opposing side of the PCB. The PCB core structure may include a laminated core comprising an inner core comprising a plurality of conductive layers (N-1 layers), a first dielectric layer disposed over an (N-1)th conductive layer of the inner core, and an Nth conductive layer over the first dielectric layer. The PCB core structure may also include a first conductive trace disposed over the Nth conductive layer on a first side of the laminated core. The PCB core structure may also include a signal via extending from a first conductive layer to an Nth conductive layer through the laminated core, the signal via configured to connect the first conductive trace to a pin or a second conductive trace on a second side of the laminated core. The PCB core structure may also include a shielding structure surrounding the signal via and partially extending from the first conductive layer to the Nth conductive layer. The PCB core structure may also include a cavity formed by removing a portion of the shielding structure in the Nth conductive layer and filled with a dielectric material, wherein the cavity filled with the dielectric material prevents the first conductive trace from shorting to the shielding structure.

In another aspect, a method may be provided for forming a PCB core structure for the transition of signals from one side of a printed circuit board (PCB) to an opposing side of the PCB. The method may include providing a laminated core comprising an inner core comprising a plurality of conductive layers (N-1 layers), a first dielectric layer disposed over the (N-1)th conductive layer of the inner core, and an Nth conductive layer over the first RF-friendly dielectric layer. The method may also include forming a first conductive trace disposed over the Nth conductive layer on a first side of the laminated core. The method may also include generating a signal via extending from a first conductive layer to an Nth conductive layer through the laminated core, the signal via configured to connect the first conductive trace to a pin or a second conductive trace on a second side of the laminated core. The method may also include creating a shielding structure surrounding the signal via and partially extending from the first conductive layer to the Nth conductive layer. The method may further include forming a cavity by removing a portion of the shielding structure in the Nth conductive layer and filled with a dielectric material, wherein the cavity filled with the dielectric material prevents the first conductive trace from shorting to the shield structure.

Additional embodiments and features are set forth in part in the description that follows and will become apparent to those skilled in the art upon examination of the specification or may be learned by the practice of the disclosed subject matter. A further understanding of the nature and advantages of the disclosure may be realized by reference to the remaining portions of the specification and the drawings, which form a part of this disclosure.

### BRIEF DESCRIPTION OF THE DRAWINGS

The description will be more fully understood with reference to the following figures and data graphs, which are presented as various embodiments of the disclosure and should not be construed as a complete recitation of the scope of the disclosure, wherein:
FIG. 1A illustrates a signal transition from horizontal to horizontal (H2H) or trace to trace according to an embodiment of the present disclosure;
FIG. 1B illustrates a signal transition from vertical to horizontal (V2H) or chip to trace according to an embodiment of the present disclosure;
FIG. 1C illustrates a signal transition from vertical to vertical (V2V) or chip to chip according to an embodiment of the present disclosure;
FIG. 2 illustrates discontinuities in signal transitions through printed circuit boards (PCBs) according to an embodiment of the present disclosure;
FIG. 3A illustrates a poor shielding signal via construction according to an embodiment of the present disclosure;
FIG. 3B illustrates a good shielding signal via construction according to an embodiment of the present disclosure;
FIG. 3C illustrates a coaxial shielding signal via according to an embodiment of the present disclosure;
FIG. 4A illustrates one exterior signal trace into a signal via in the middle of ground vias when using through vias according to an embodiment of the present disclosure;
FIG. 4B illustrates two exterior signal traces into a signal via in the middle of ground vias when using through vias according to an embodiment of the present disclosure;
FIG. 4C illustrates an exterior signal trace necked down to pass between two ground vias into a signal via in the middle of ground vias when using through vias according to an embodiment of the present disclosure;
FIG. 5A illustrates a via shielding structure including buried vias and blind vias using two or more lamination cycles to avoid shorting signals and leakage losses in H2H transitions according to an embodiment of the present disclosure;
FIG. 5B illustrates a via shielding structure including buried vias and blind vias using two or more lamination cycles to avoid shorting signals and leakage losses in V2H transitions according to an embodiment of the present disclosure;
FIG. 6A illustrates a PCB core structure removing a portion of one or more ground fencing vias that may interfere with an entry/exit trace and replacing the removed material with a dielectric material on which a crossing trace can be formed in H2H transitions according to an embodiment of the present disclosure;
FIG. 6B illustrates a PCB core structure removing a portion of one or more ground fencing vias that may interfere with an entry or exit trace and replacing the removed material with a dielectric material on which a crossing trace can be formed in V2H transitions according to an embodiment of the present disclosure;
FIG. 7A illustrates an exploded perspective view of a via-fencing construction with cavities formed by removing part of multiple ground vias that may interfere with an entry or exit trace using a single-lamination cycle according to an embodiment of the present disclosure;
FIG. 7B illustrates a side view of the via-fencing construction of FIG. 7A using a single-lamination cycle according to an embodiment of the present disclosure;
FIG. 7C illustrates a top view of the via-fencing construction of FIGs. 7A and 7B using a single-lamination cycle according to an embodiment of the present disclosure;
FIG. 8A is a diagram illustrating an etching and laminating operation for forming the via-fencing construction of FIGs.7A-7C using a single-lamination cycle according to an embodiment of the present disclosure;
FIG. 8B is a diagram illustrating a drilling operation for forming through vias and blind vias of the via-fencing construction of FIGs.7A-7C using a single-lamination cycle according to an embodiment of the present disclosure;
FIG. 8C is a diagram illustrating a plating operation for forming the via-fencing construction of FIGs.7A-7C using a single-lamination cycle according to an embodiment of the present disclosure;
FIG. 8D is a diagram illustrating a controlled depth drilling operation for forming cavities of the via-fencing construction of FIGs.7A-7C using a single-lamination cycle according to an embodiment of the present disclosure;
FIG. 8E is a diagram illustrating a filling operation for forming the via-fencing construction of FIGs.7A-7C using a single-lamination cycle according to an embodiment of the present disclosure;
FIG. 8F is a diagram illustrating a panel plating operation for forming the via-fencing construction of FIGs.7A-7C using a single-lamination cycle according to an embodiment of the present disclosure;

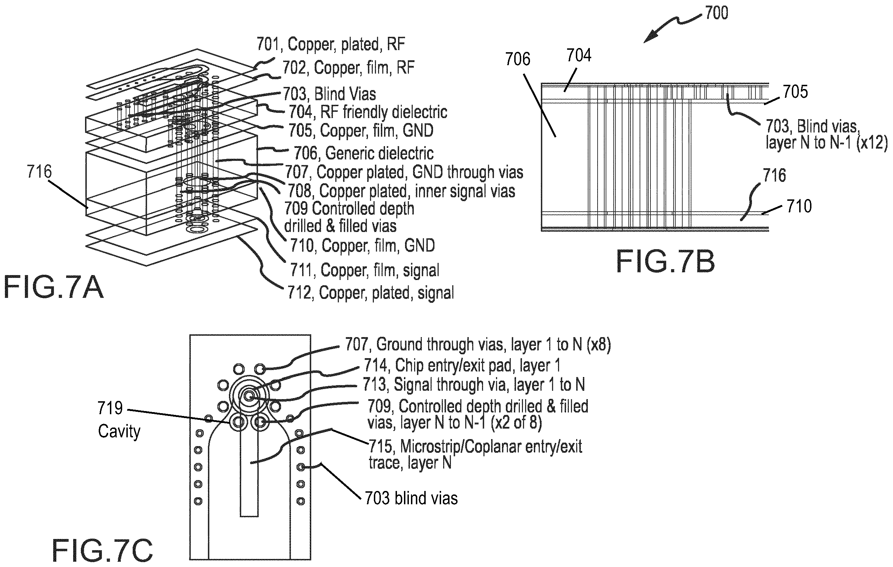

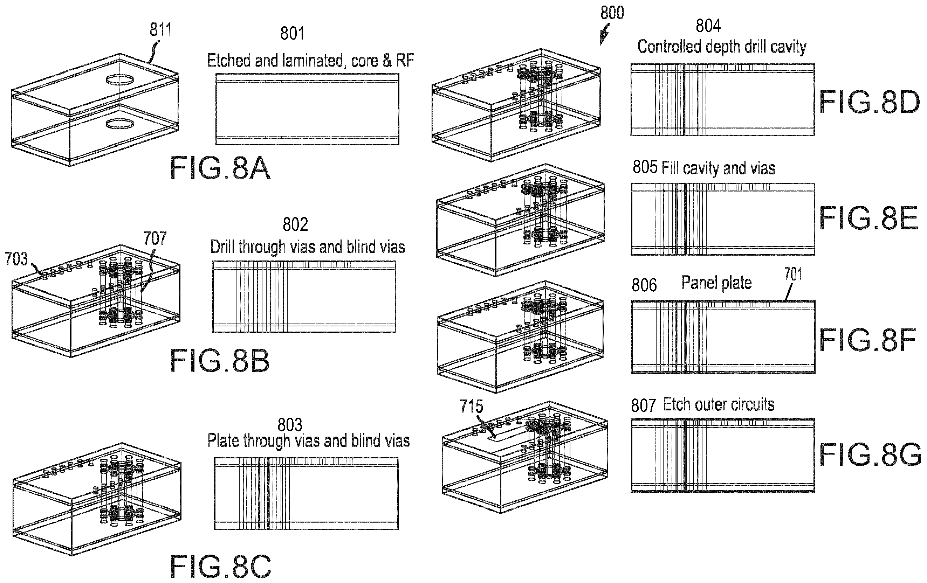

FIG. 8F is a diagram illustrating an etching operation for forming outer circuits of the via-fencing construction of FIGs.7A-7C using a single-lamination cycle according to an embodiment of the present disclosure;

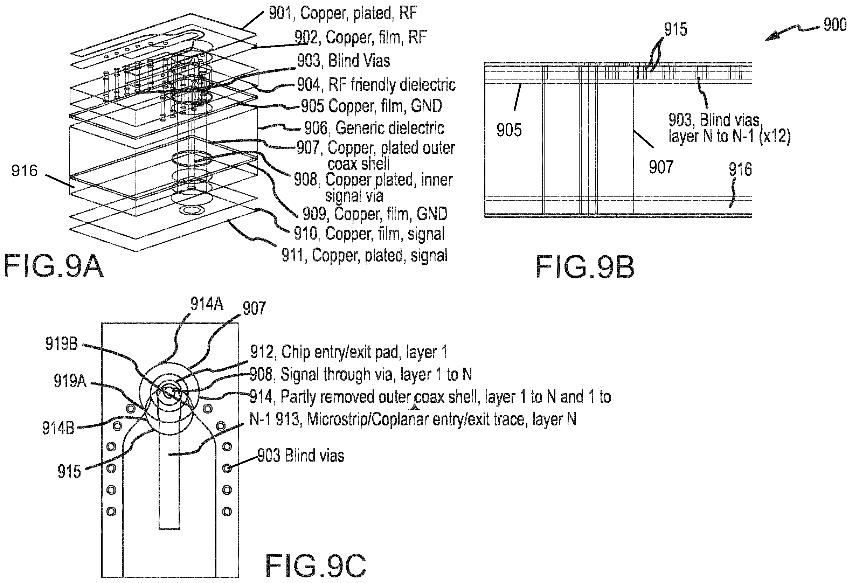

FIG. 9A illustrates an exploded perspective view of a coaxial construction with cavities formed by removing part of an outer shell of a large via that may interfere with an entry or exit trace using a single-lamination cycle according to an embodiment of the present disclosure;
FIG. 9B illustrates a side view of the coaxial construction of FIG. 9A using a single-lamination cycle according to an embodiment of the present disclosure;
FIG. 9C illustrates a top view of the coaxial construction of FIGs. 9A and 9B using a single-lamination cycle according to an embodiment of the present disclosure;

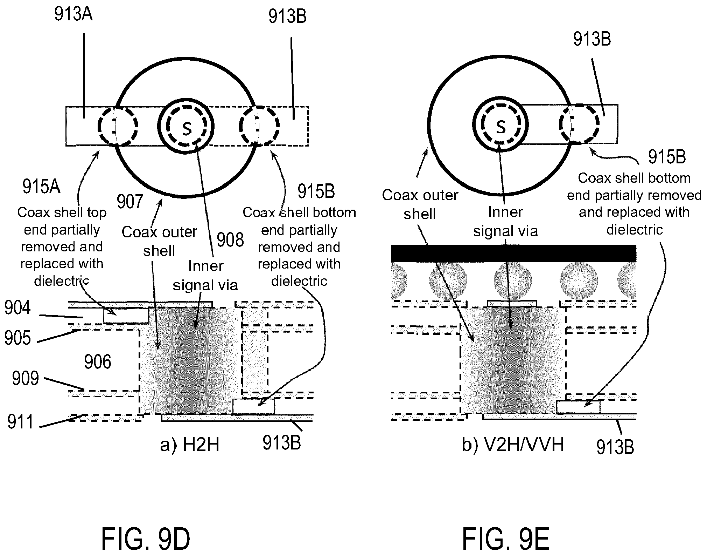

FIG. 9D illustrates a PCB core structure including the coaxial construction of FIGs. 9A-9C removing a portion of a coaxial outer shell that may interfere with an entry/exit trace and replacing the removed material with a dielectric material on which a crossing trace can be formed in H2H transitions according to an embodiment of the present disclosure;
FIG. 9E illustrates a PCB core structure including the coaxial construction of FIGs. 9A-9C removing a portion of a coaxial outer shell that may interfere with an entry or exit trace and replacing the removed material with a dielectric material on which a crossing trace can be formed in V2H transitions according to an embodiment of the present disclosure;

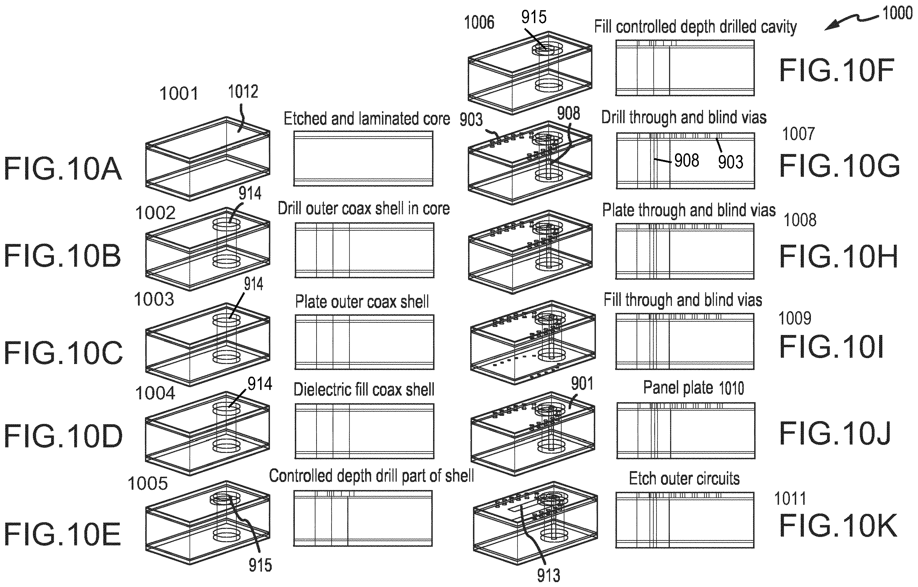

FIG. 10A is a diagram illustrating a laminating operation for forming the coaxial construction of FIGs. 9A-9C using a single-lamination cycle according to an embodiment of the present disclosure;
FIG. 10B is a diagram illustrating a drilling operation for forming an outer coaxial shell of the coaxial construction of FIGs. 9A-9C using a single-lamination cycle according to an embodiment of the present disclosure;
FIG. 10C is a diagram illustrating a plating operation for forming the coaxial construction of FIGs. 9A-9C using a single-lamination cycle according to an embodiment of the present disclosure;
FIG. 10D is a diagram illustrating a dielectric filling operation for forming the coaxial construction of FIGs. 9A-9C using a single-lamination cycle according to an embodiment of the present disclosure;
FIG. 10E is a diagram illustrating a controlled depth drilling operation for forming the coaxial construction of FIGs. 9A-9C using a single-lamination cycle according to an embodiment of the present disclosure;
FIG. 10F is a diagram illustrating a controlled depth cavity filling operation for forming a cavity of the coaxial construction of FIGs. 9A-9C using a single-lamination cycle according to an embodiment of the present disclosure;
FIG. 10G is a diagram illustrating a drilling operation for forming through vias and blind vias of the coaxial construction of FIGs. 9A-9C using a single-lamination cycle according to an embodiment of the present disclosure;
FIG. 10H is a diagram illustrating a plating operation for forming the coaxial construction of FIGs. 9A-9C using a single-lamination cycle according to an embodiment of the present disclosure;
FIG. 10I is a diagram illustrating a dielectric filling operation for forming the coaxial construction of FIGs. 9A-9C using a single-lamination cycle according to an embodiment of the present disclosure;
FIG. 10J is a diagram illustrating a panel plating operation for forming the coaxial construction of FIGs. 9A-9C using a single-lamination cycle according to an embodiment of the present disclosure;
FIG. 10K is a diagram illustrating an etching operation for forming outer circuits of the coaxial construction of FIGs. 9A-9C using a single-lamination cycle according to an embodiment of the present disclosure;

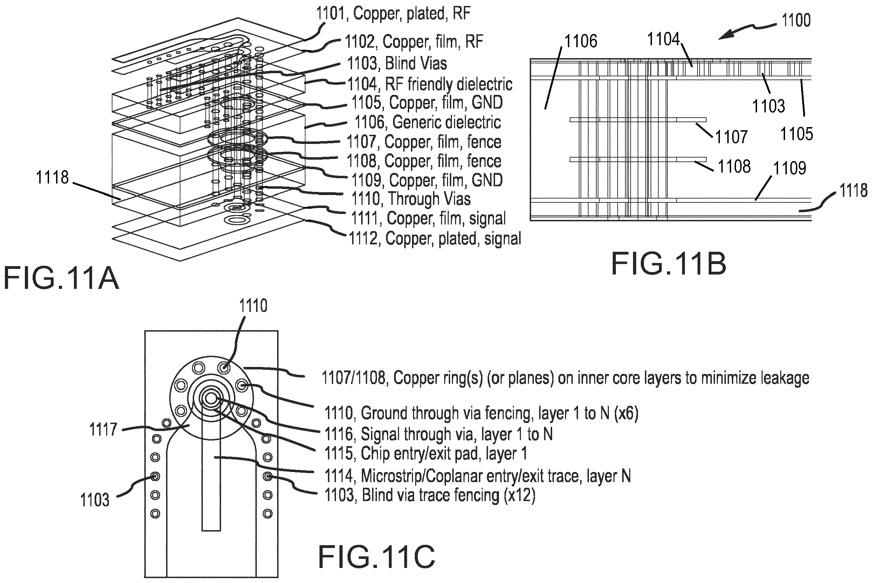

FIG. 11A illustrates an exploded perspective view of a partial via-fencing construction using a single-lamination cycle according to an embodiment of the present disclosure;
FIG. 11B illustrates a side view of the partial via-fencing construction of FIG. 11A using a single-lamination cycle according to an embodiment of the present disclosure;
FIG. 11C illustrates a top view of the partial via-fencing construction of FIGs. 11A-11B using a single-lamination cycle according to an embodiment of the present disclosure;

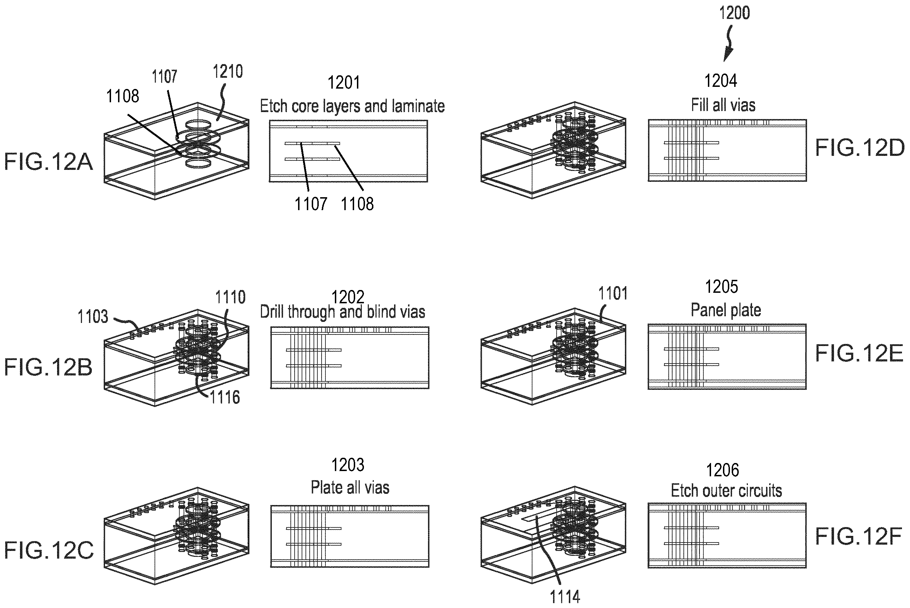

FIG. 12A is a diagram illustrating an etching and laminating operation for forming the partial via-fencing construction of FIGs. 11A-11C using a single-lamination cycle starting from a laminated core construction according to an embodiment of the present disclosure;
FIG. 12B is a diagram illustrating a drilling operation for forming through vias and blind vias of the partial via-fencing construction of FIGs. 11A-11C using a single-lamination cycle starting from a laminated core construction according to an embodiment of the present disclosure;
FIG. 12C is a diagram illustrating a plating operation for forming the partial via-fencing construction of FIGs. 11A-11C using a single-lamination cycle starting from a laminated core construction according to an embodiment of the present disclosure;
FIG. 12D is a diagram illustrating a dielectric filling operation for forming the partial via-fencing construction of FIGs. 11A-11C using a single-lamination cycle starting from a laminated core construction according to an embodiment of the present disclosure;
FIG. 12E is a diagram illustrating a panel plating operation for forming the partial via-fencing construction of FIGs. 11A-11C using a single-lamination cycle starting from a laminated core construction according to an embodiment of the present disclosure;
FIG. 12F is a diagram illustrating an etching operation for forming outer circuits of the partial via-fencing construction of FIGs. 11A-11C using a single-lamination cycle starting from a laminated core construction according to an embodiment of the present disclosure;

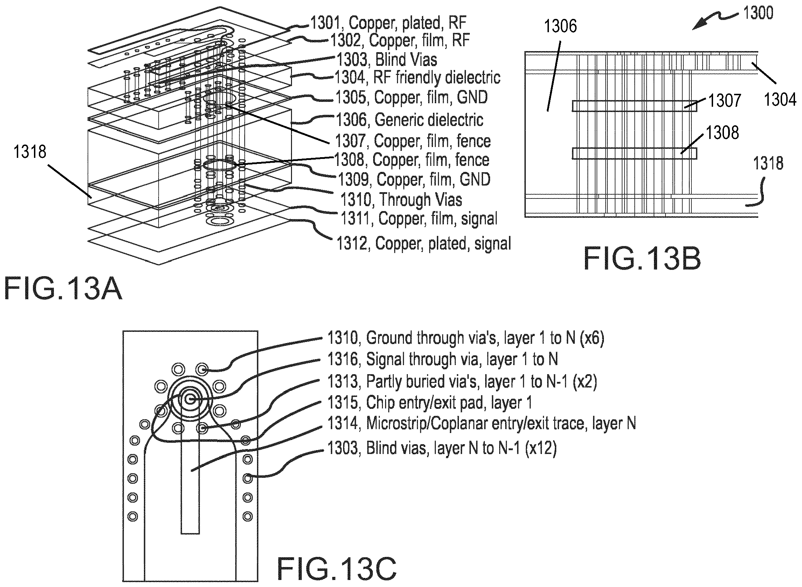

FIG. 13A illustrates an exploded perspective view of a via-fencing construction using dual-lamination cycles according to an embodiment of the present disclosure;
FIG. 13B illustrates a side view of the via-fencing construction of FIG. 13A using dual-lamination cycles according to an embodiment of the present disclosure;
FIG. 13C illustrates a top view of the via-fencing construction of FIGs. 13A-13B using dual-lamination cycles according to an embodiment of the present disclosure;

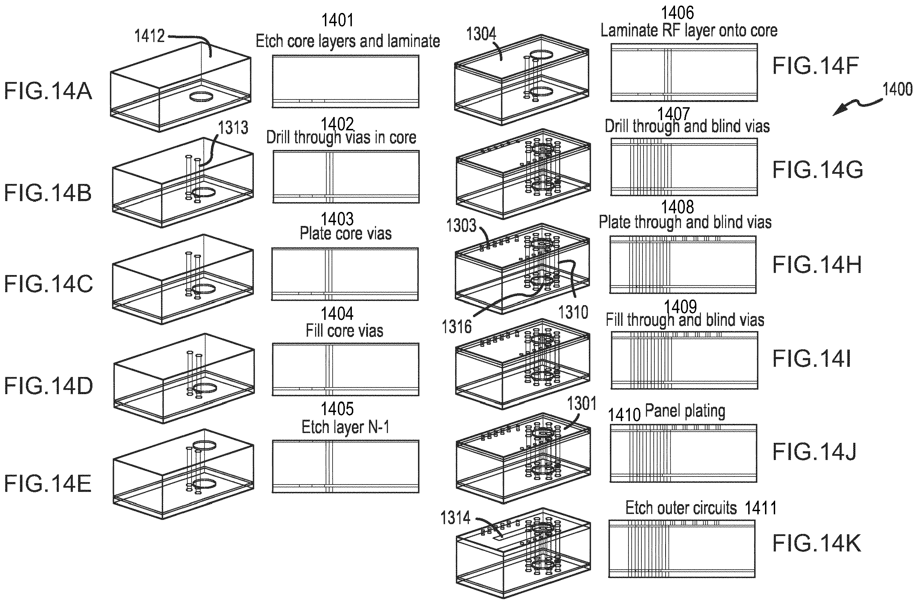

FIG. 14A is a diagram illustrating an etching and laminating operation for forming the via-fencing construction of FIGs. 13A-13C using dual-lamination cycles according to an embodiment of the present disclosure;
FIG. 14B is a diagram illustrating a drilling operation for forming through vias of the via-fencing construction of FIGs. 13A-13C using dual-lamination cycles according to an embodiment of the present disclosure;
FIG. 14C is a diagram illustrating a plating operation for forming the via-fencing construction of FIGs. 13A-13C using dual-lamination cycles according to an embodiment of the present disclosure;
FIG. 14D is a diagram illustrating a dielectric filling operation for forming the via-fencing construction of FIGs. 13A-13C using dual-lamination cycles according to an embodiment of the present disclosure;
FIG. 14E is a diagram illustrating an etching operation for forming the via-fencing construction of FIGs. 13A-13C using dual-lamination cycles according to an embodiment of the present disclosure;
FIG. 14F is a diagram illustrating a laminating operation for adding an RF layer to the core of forming the via-fencing construction of FIGs. 13A-13C using dual-lamination cycles according to an embodiment of the present disclosure;
FIG. 14G is a diagram illustrating a drilling operation for forming through vias and blind vias of the via-fencing construction of FIGs. 13A-13C using dual-lamination cycles according to an embodiment of the present disclosure;
FIG. 14H is a diagram illustrating a plating operation for forming the via-fencing construction of FIGs. 13A-13C using dual-lamination cycles according to an embodiment of the present disclosure;
FIG. 14I is a diagram illustrating a dielectric filling operation for forming the via-fencing construction of FIGs. 13A-13C using dual-lamination cycles according to an embodiment of the present disclosure;
FIG. 14J is a diagram illustrating a panel plating operation for forming the via-fencing construction of FIGs. 13A-13C using dual-lamination cycles according to an embodiment of the present disclosure;
FIG. 14K is a diagram illustrating an etching operation for forming outer circuits of the via-fencing construction of FIGs. 13A-13C using dual-lamination cycles according to an embodiment of the present disclosure;

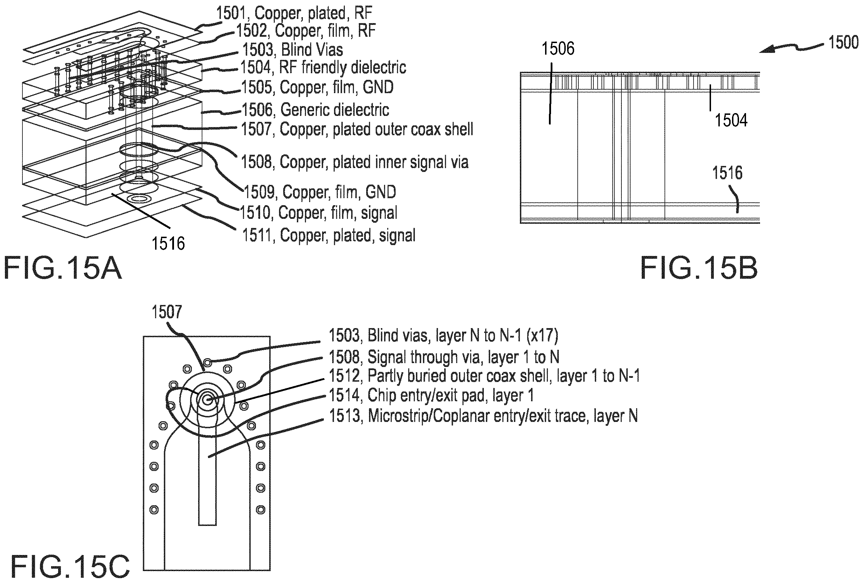

FIG. 15A illustrates an exploded perspective view of a coaxial construction using dual-lamination cycles according to an embodiment of the present disclosure;
FIG. 15B illustrates a side view of the coaxial construction of FIG. 15A using dual-lamination cycles according to an embodiment of the present disclosure;
FIG. 15C illustrates atop view of the coaxial construction of FIGs. 15A-15B using dual-lamination cycles according to an embodiment of the present disclosure;

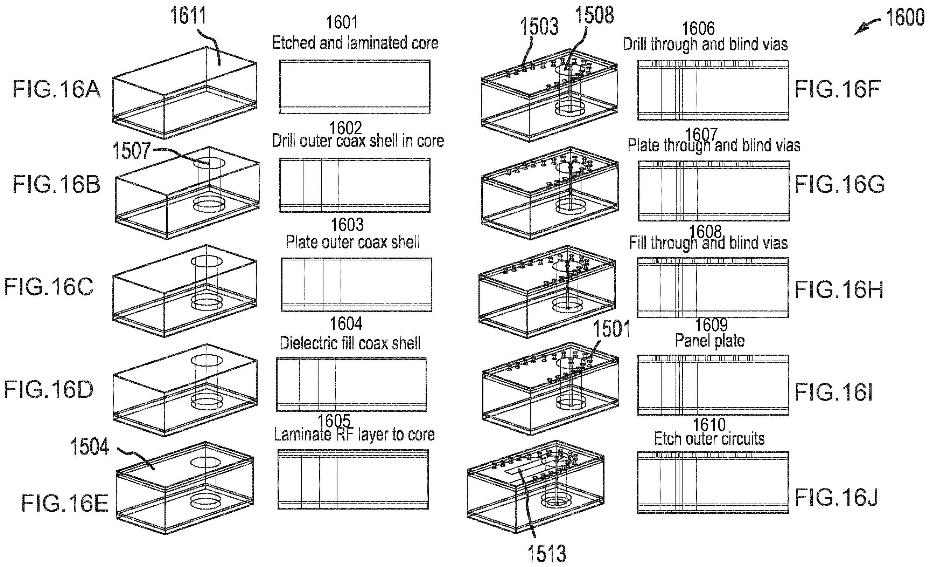

FIG. 16A is a diagram illustrating a first laminating operation for forming the coaxial construction of FIGs. 15A-15C using dual-lamination cycles according to an embodiment of the present disclosure;
FIG. 16B is a diagram illustrating a drilling operation for forming an outer coaxial shell of the coaxial construction of FIGs. 15A-15C using dual-lamination cycles according to an embodiment of the present disclosure;
FIG. 16C is a diagram illustrating a plating operation for forming the coaxial construction of FIGs. 15A-15C using dual-lamination cycles according to an embodiment of the present disclosure;
FIG. 16D is a diagram illustrating a dielectric filling operation for forming the coaxial construction of FIGs. 15A-15C using dual-lamination cycles according to an embodiment of the present disclosure;
FIG. 16E is a diagram illustrating a second laminating operation for adding an RF layer to the core of the coaxial construction of FIGs. 15A-15C using dual-lamination cycles according to an embodiment of the present disclosure;
FIG. 16F is a diagram illustrating a drilling operation for forming the through vias and blind vias of the coaxial construction of FIGs. 15A-15C using dual-lamination cycles according to an embodiment of the present disclosure;
FIG. 16G is a diagram illustrating a plating operation for forming the coaxial construction of FIGs. 15A-15C using dual-lamination cycles according to an embodiment of the present disclosure;
FIG. 16H is a diagram illustrating a filling operation for forming the coaxial construction of FIGs. 15A-15C using dual-lamination cycles according to an embodiment of the present disclosure;
FIG. 16I is a diagram illustrating a panel plating operation for forming the coaxial construction of FIGs. 15A-15C using dual-lamination cycles according to an embodiment of the present disclosure;
FIG. 16J is a diagram illustrating an etching operation for forming the outer circuits of the coaxial construction of FIGs. 15A-15C using dual-lamination cycles according to an embodiment of the present disclosure;

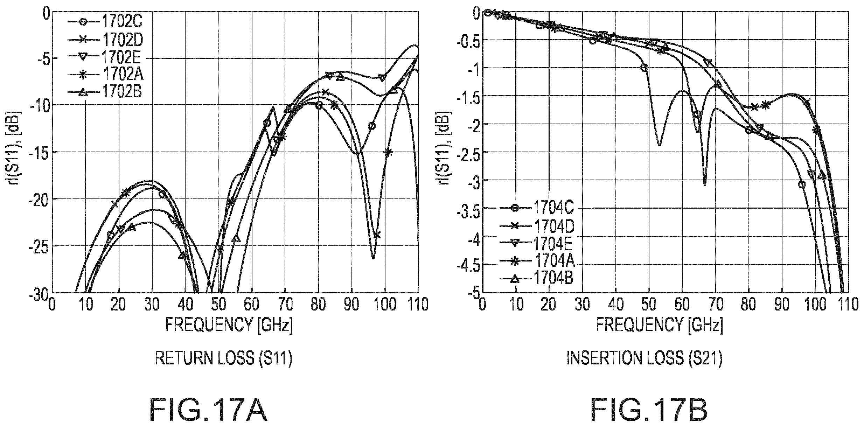

FIG. 17A illustrates return loss versus frequency for various shield signal vias according to an embodiment of the present disclosure;
FIG. 17B illustrates insertion loss versus frequency for various shield signal vias according to an embodiment of the present disclosure;

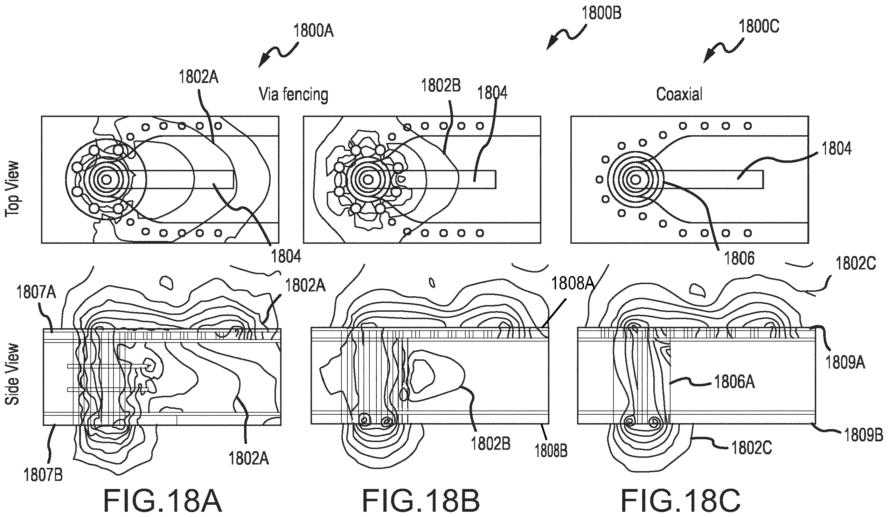

FIG. 18A shows a top view and a side view of Evanescent field contour lines for the partial via-fencing construction of FIGs. 11A-11C using a single-lamination cycle according to an embodiment of the present disclosure;
FIG. 18B shows a top view and a side view of Evanescent field contour lines for the via-fencing construction of FIGs. 13A-13C using dual-lamination cycles according to an embodiment of the present disclosure;
FIG. 18C shows a top view and a side view of Evanescent field contour lines for the coaxial construction of FIGs. 15A-15C using dual-lamination cycles according to an embodiment of the present disclosure;

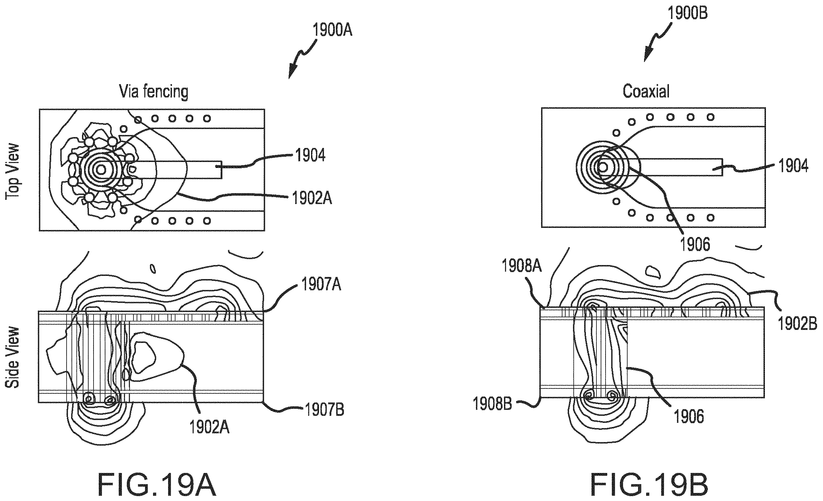

FIG. 19A shows a top view and a side view of Evanescent field contour lines for a via-fencing construction of FIGs. 7A-7C using a single- lamination cycle according to an embodiment of the present disclosure;
FIG. 19B shows a top view and a side view of Evanescent field contour lines for a coaxial construction of FIGs. 9A-9C using a single- lamination cycle according to an embodiment of the present disclosure;

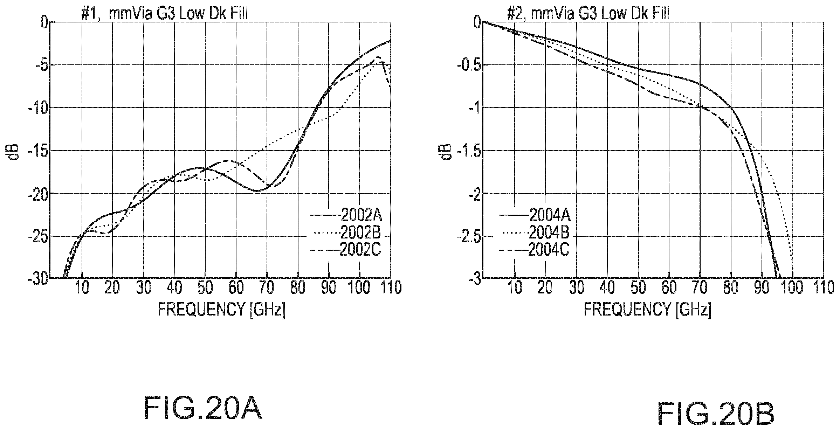

FIG. 20A shows simulated return loss versus frequency for the via-fencing construction of FIGs. 7A-7C with various PCB heights according to an embodiment of the present disclosure; and
FIG. 20B shows simulated insert loss versus frequency for the via-fencing construction of FIGs. 7A-7C with various PCB heights according to an embodiment of the present disclosure;

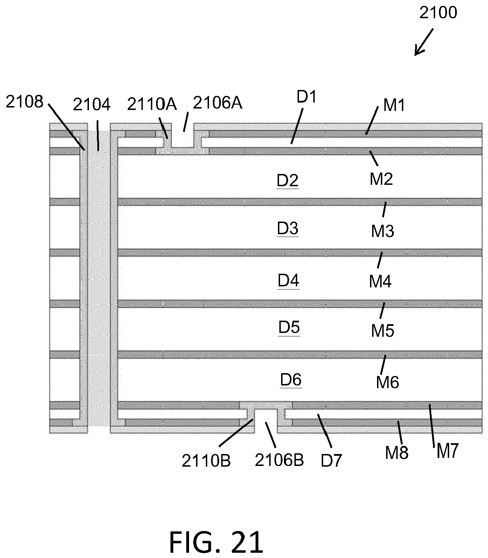

FIG. 21 illustrates a cross-sectional view of an example PCB fabricated with a single lamination cycle according to an embodiment of the present disclosure;

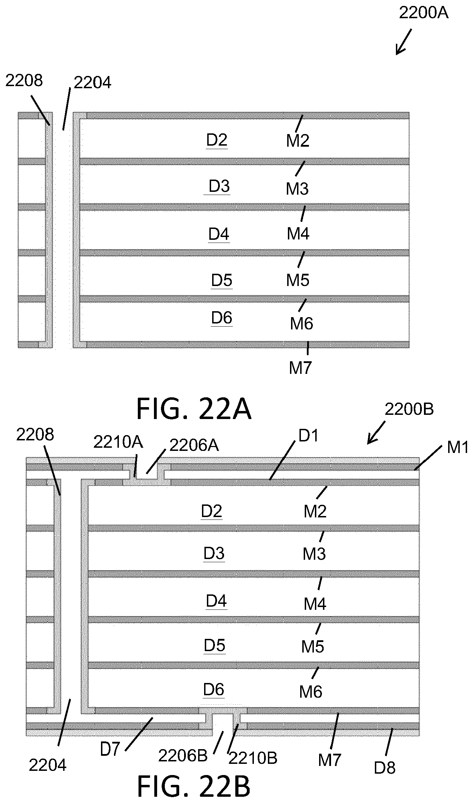

FIG. 22A illustrates a cross-sectional view of an example inner core of a PCB fabricated with a first lamination cycle in dual-lamination cycles according to an embodiment of the present disclosure;
FIG. 22B illustrates a cross-sectional view of an example PCB including outer layers formed with a second lamination cycle in dual-lamination cycles according to an embodiment of the present disclosure; and

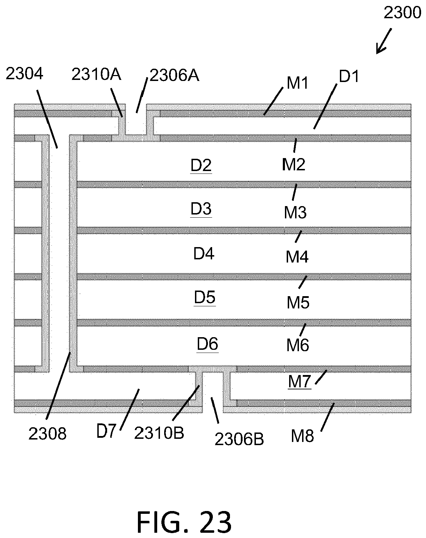

FIG. 23 illustrates a cross-sectional view of a PCB fabricated with a first lamination cycle in dual-lamination cycles according to an embodiment of the present disclosure.

### DETAILED DESCRIPTION

The disclosure may be understood by reference to the following detailed description, taken in conjunction with the drawings as described below. It is noted that, for purposes of illustrative clarity, certain elements in various drawings may not be drawn to scale.

At high frequencies (e.g., µWave or mmWave) and broadband signals, such as high-speed digital signals, Ethernet, or low voltage differential signals (LVDS), it is important to use a controlled impedance signal interconnect. Microwave (µWave) signals generally refer to signals with frequencies of 1-30 GHz and corresponding free space wavelengths of 1 to 30 cm, while mmWave signals typically refer to signals having free space wavelengths in the range from 1 millimeter to 10 millimeters, or 30-300 GHz. It is more difficult to transition vertically through the PCB than the transition in a single horizontal plane where lines can be etched consistently. Because of the difficulty, interconnects from one side of the PCB to the other side of the PCB are often avoided. For example, all broadband and/or high-frequency signals are on one side of the PCB, such as in most current automotive radar implementations.

However, there are system advantages for routing broadband and/or high-speed signals from one side of the PCB to another side of the PCB. For example, one PCB assembly includes all components on one side of the PCB and antennas printed on the opposing side of the PCB. The PCB assembly has cost savings due to assembly being on one side and also has the advantage that the opposing side where antenna arrays are printed can be entirely flat, which facilitates a radome being mounted directly on the top of the antenna arrays. The radome is a structural weatherproof enclosure that protects the antenna arrays. A distribution feed network can be constructed on one side of the PCB to feed the antenna arrays on the other side of the PCB, facilitating the feeding of the antenna arrays from the center. The center-feeding antenna arrays have performance benefits.

The present technology provides a PCB core structure including a shielding structure for a signal transition from one side of a PCB to the other side of the PCB. The PCB facilitates transitioning high frequency and broadband (0 to 90 GHz) signals from one side of a PCB to the other side of the PCB with low loss, low leakage, or zero leakage into the PCB core layers. The signals are fully shielded through the PCB core structure including entry trace and/or exit trace, thus preventing leakage into the PCB core structure and reducing leakage losses and crosstalk. The shielding structure is compact and thus facilitates a close pitch of signals in interfacing with a chip with signals nearby, such as a pitch of 0.5 mm. The PCB core structure may use radio frequency (RF) core materials as an outer layer(s).

The present technology provides methods for manufacturing a high-frequency and/or broadband signal transition from one exterior side of a PCB to the other side of the PCB. The methods use a single-lamination cycle, which is used for a via shield including a via-fencing construction or a coaxial construction. The via shield is conducive to applications having a top performance at a low cost. The present technology lowers the fabrication cost for implementing a shielded via in PCB by using the single-lamination cycle to reduce the cost associated with a second lamination cycle and replacing the second lamination cycle with a low-cost dielectric cavity fill operation.

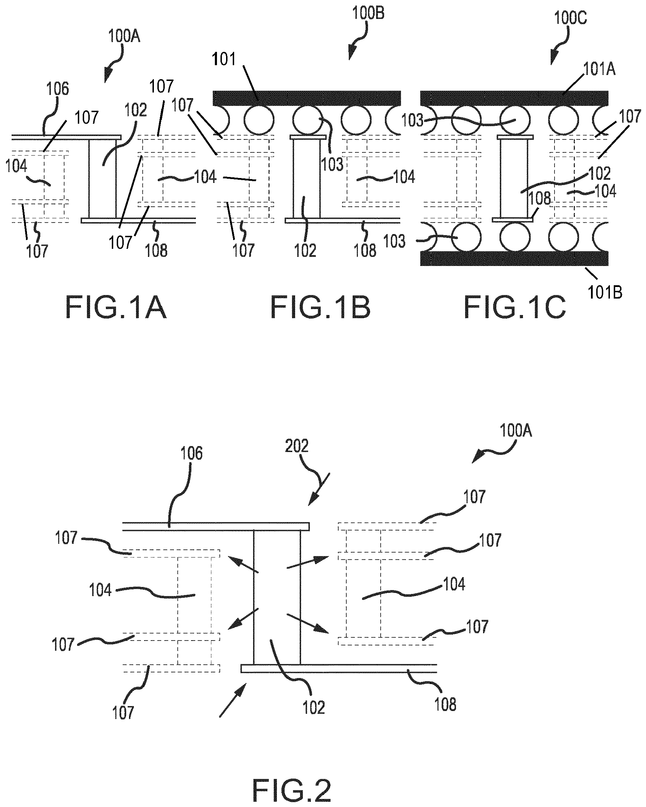

Different types of transitions may be defined depending on specific needs. FIG. 1A illustrates a signal transition from horizontal to horizontal (H2H) or trace to trace according to an embodiment of the present disclosure. A signal in a top conductive trace 106 on one exterior layer of a PCB 100A transitions to a bottom conductive trace 108 on an opposing exterior side of the PCB, through a signal via 102 shielded by ground vias 104 surrounding the signal via 102. The transition for the signal may be referred to as a horizontal to vertical to horizontal transition (H2H or HVH), as illustrated in FIG. 1A, because the signal via 102 vertically connects to the top horizontal trace and the bottom horizontal trace.

FIG. 1B illustrates a signal transition from vertical to horizontal (V2H) or chip to trace according to an embodiment of the present disclosure. As illustrated in FIG. 1B, a signal originates from pin 103 of chip 101 on one side (e.g., top side) of a PCB 100B and transitions to a bottom conductive trace 108 on an opposing side (e.g., bottom side) of the PCB 100B through signal via 102 shielded by ground vias 104 surrounding the signal via 102. The transition for the signal may be referred to as vertical to vertical to horizontal (V2H/VVH) transition, as illustrated in FIG. 1B, because the signal via 102 vertically connects to the top pin 103 to the bottom horizontal trace 108.

FIG. 1C illustrates a signal transition from vertical to vertical (V2V) or chip to chip according to an embodiment of the present disclosure. As illustrated in Fig. 1C, a signal originates from pin 103 of a first chip 101A on one side (e.g., a top side) of a PCB 100C and needs to go to another pin 103 of a second chip 101B on an opposing side (e.g., a bottom side) of the PCB 100C through signal via 102 shielded by ground vias 104 surrounding the signal via 102. The transition for the signal may be referred to as vertical to vertical (V2V/VVV) transition, as illustrated in FIG. 1C, because the signal via vertically connects to the top pin 103 and the bottom pin 103.

However, the transition from horizontal to vertical (H2V) may include an impedance discontinuity. FIG. 2 illustrates discontinuities in signal transitions through PCBs according to an embodiment of the present disclosure. As illustrated in FIG. 2, the PCB 100A may include impedance discontinuities 202 between the top conductive trace 106 and signal via 102, between the bottom conductive trace 108 and the signal via 102, or between conductive layers 107 and ground via 104, as pointed to by arrows. Further discontinuities may occur as a function of the variations in the material dielectric constant for the different cores and pre-preg materials used in the construction of the PCB and limitations of the dimensions for the vertically formed structures in comparison to limitations to dimensions in the horizontal plane. The discontinuities and variations may affect performance and limit the upper frequency and the bandwidth for the signals.

For high frequency and broadband signals, it is important to contain or shield the signal to reduce leakage losses leading to performance degradation of the signal itself and to reduce crosstalk between signals leading to system performance degradation and/or electromagnetic interference (EMI) compliancy issues.

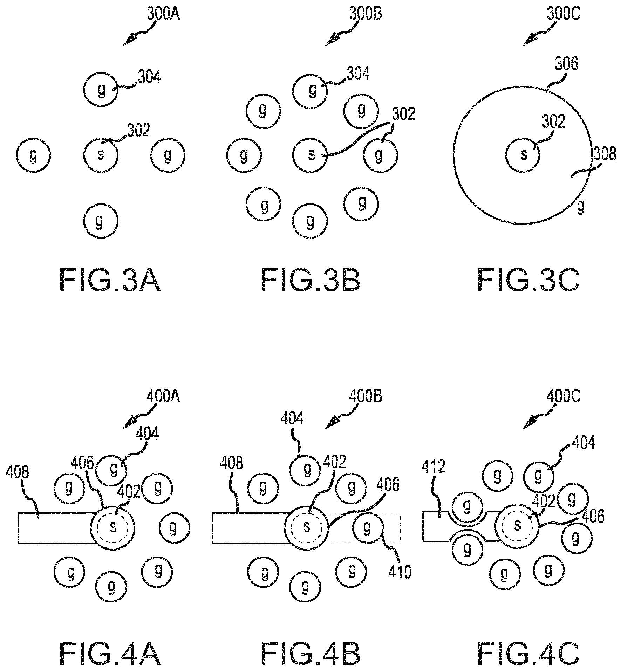

FIG. 3A illustrates a poor shielding signal via construction according to an embodiment of the present disclosure. As illustrated in FIG. 3A, a via shielding structure 300A includes a signal via in a center and a small number of ground vias (e.g., four ground vias) which surround the signal via 302 in the center. The signal via 302 may be a poorly shielded signal via at high frequency, e.g., 77 GHz.

FIG. 3B illustrates a good shielding signal via construction for reducing leakage according to an embodiment of the present disclosure. As illustrated in FIG. 3B, a structure 300B includes a signal via in a center and a large number of ground vias (e.g., eight ground vias) that surround the signal via 302 in the center. The signal via 302 in via shielding structure 300B may be better shielded than the signal via 302 in via shielding structure 300A at high frequency, e.g., 77 GHz. When using a plurality of ground vias 304 for shielding, the ground vias 304 in via shielding structure 300B can be close enough to each other relative to the signal wavelength at an upper-frequency threshold to reduce any evanescent fields. At high frequencies, e.g., 77 GHz, the distance between the ground vias 304 to be effective is on the order of 0.2 mm or less, which is about the size of the ground via 304.

FIG. 3C illustrates a coaxial shielding signal via for reducing leakage according to an embodiment of the present disclosure. As illustrated in FIG. 3C, a coaxial via shielding structure 300C may include a signal via 302 in the center with a single large via 306 forming a coaxial shield. The signal via 302 is completely shielded using the coaxial via shielding structure 300C. In the coaxial via shielding structure 300C, the signal via 302 is inside the large ground via 306, which can be filled with a dielectric material 308 to allow the signal via 302 to be formed in the center.

The ground vias 304 or large via 306 are through-ground vias, which may extend from an exterior conductive trace on one side of a PCB to an exterior conductive trace on the other side of the PCB, which works for the V2V transition, but may not work for the H2H or V2H transition as the conductive trace 106 or 108 cannot pass between the ground vias 104.

FIG. 4A illustrates one exterior signal trace into a signal via in the middle of ground vias when using through ground vias according to an embodiment of the present disclosure. As illustrated in FIG. 4A, a via shielding structure 400A includes a signal via 402 surrounded by ground vias 404, and a signal trace 408 into the signal via 402 on one side of a PCB. Conductive pad 406 is also referred to as a via catch pad and is a part of the signal trace 408 in the same plane as trace 408 and formed at the same time. The ground vias 404 are through ground vias in the PCB. The via shielding structure 400A uses seven ground vias 404 with one ground via removed to allow the signal trace 408 to pass through, such that the signal via 402 may be poorly shielded due to the missing ground via.

FIG. 4B illustrates two exterior signal traces into a signal via in the middle of ground vias when using through vias according to an embodiment of the present disclosure. As illustrated in FIG. 4B, via shielding structure 400B includes a signal via 402 surrounded by ground vias 404, and signal traces 408 and 410 into the signal via 402 on both exterior sides of a PCB. The ground vias 404 are through vias in the PCB. The via shielding structure 400B uses six ground vias 404 with two ground vias removed to allow the signal traces 408 and 410 to pass through, such that the signal via 402 may be poorly shielded due to the missing ground vias.

FIG. 4C illustrates an exterior signal trace necked down to pass between two ground vias into a signal via in the middle of ground vias when using through vias according to an embodiment of the present disclosure. As illustrated in FIG. 4C, a via shielding structure 400C includes a signal via 402 surrounded by eight ground vias 404, and a signal trace 412 into the signal via 402 on one exterior side of a PCB. The ground vias 404 are through vias in the PCB. the signal trace 412 may be necked down to fit the signal trace 402 between two neighboring ground vias 404. It would be difficult to maintain consistent impedance for the via shielding structure 400C. As such, the bandwidth and upper operating frequency may be reduced significantly.

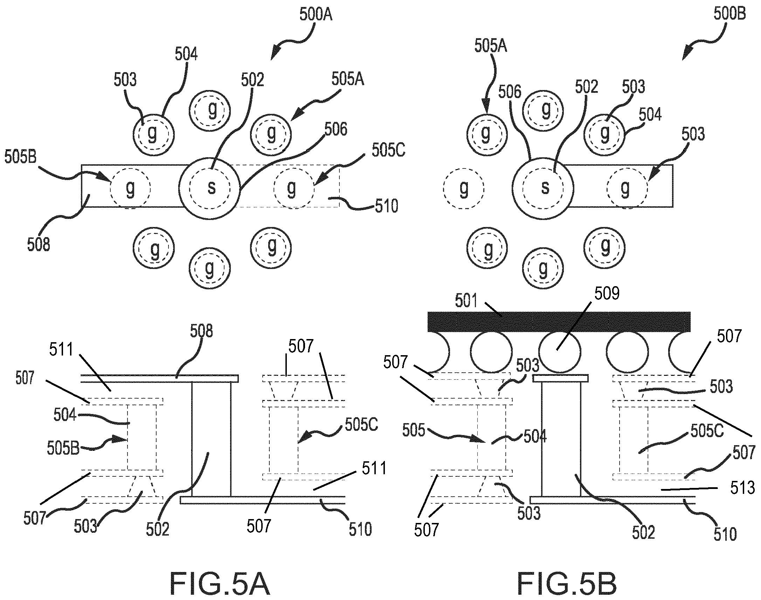

FIG. 5A illustrates a via shielding structure including buried vias and blind vias using two or more lamination cycles to avoid shorting signals and leakage losses in H2H transitions according to an embodiment of the present disclosure. As illustrated in FIG. 5A, a top portion is a top view of via shield structure 500A and a bottom portion is a sectional view of via shield structure 500A. Via shield structure 500A includes a signal via 502 surrounded by many fencing vias 505A including buried vias 504 and top and bottom blind vias 503, such as six fencing vias 505A.

Via shield structure 500A also includes a top trace 508 on one side of a PCB and a bottom trace 510 on an opposing side of the PCB. The top trace 508 and the bottom trace 510 are connected to the signal via 502. Conductive pad 506 is also referred to as a via catch pad and is essentially a part of the top trace 508 in the same plane as the top trace 508 and formed at the same time.

Via shield structure 500A also includes fencing via 505B including a buried via 504 under the top trace 508 and a blind via 503 under the buried via 504. The buried via 504 connects to conductive layers 507 or ground layers. The blind via 503 also connects between two neighboring conductive layers 507 or ground layers. The fencing via 505B is separated from the top trace 508 by a core insulating material.

Via shield structure 500A also includes an upper outer layer 511 between the top trace 508 and conductive layer 507 and a lower outer layer 511 between bottom trace 510 and conductive layer 507. The outer layers 511 are formed of a dielectric material.

Via shield structure 500A also includes fencing via 505C including a blind via 503 above the bottom trace 510 and a buried via 504 above the blind via 503. The buried via 504 connects to conductive layers 507 or ground layers. The blind via 503 also connects between two neighboring conductive layers 507 or ground layers. The fencing via 505C is separated from the bottom trace 510 by a core insulating material. The eight fencing vias, including six fencing vias 505A, one fencing via 505B, and one fencing via 505C, are positioned around the signal via 502 to shield the signals.

FIG. 5B illustrates using two or more lamination cycles to form buried vias and blind vias to avoid shorting signals and leakage losses in V2H or VVH transitions according to an embodiment of the present disclosure. As illustrated in FIG. 5B, a top portion is a top view of via shield structure 500B, and a bottom portion is a sectional view of via shield structure 500B.

Via shield structure 500B includes a signal via 502 in a center, which is surrounded by many fencing vias 505A including buried vias 504 and top and bottom blind vias 503, such as seven fencing vias 505A. The buried vias 504 connect to conductive layers 507 or ground layers and are positioned between the top and bottom blind vias 503. The blind via 503 also connects between two neighboring conductive layers 507 or ground layers. Via shield structure 500B also includes a chip 501 on one side of a PCB and pins 509 connect to chip 501. Via shield structure 500B also includes a bottom trace 510 on an opposing side of the PCB. The conductive pin 509 and the bottom trace 510 are connected to the signal via 502. Via shield structure 500B also includes fencing via 505C including a buried via 504 and a blind via 503 above the bottom trace 510. The fencing via 505C is separated from the bottom trace 510 by a core insulating material. The eight fencing vias, including seven fencing vias 505A and one fencing via 505C, are positioned around the signal via 502 to shield the signals.

Via shield structure 500B also includes an outer layer 513 between bottom trace 510 and conductive layer 507. The outer layer 513 is formed of a dielectric material.

The via shield structure 500A or 500B as illustrated in FIG. 5A or FIG. 5B may be formed by using two lamination cycles. While the two lamination cycles are viable, the second lamination cycle significantly adds cost, for example, about 50% more expensive than a single-lamination cycle.

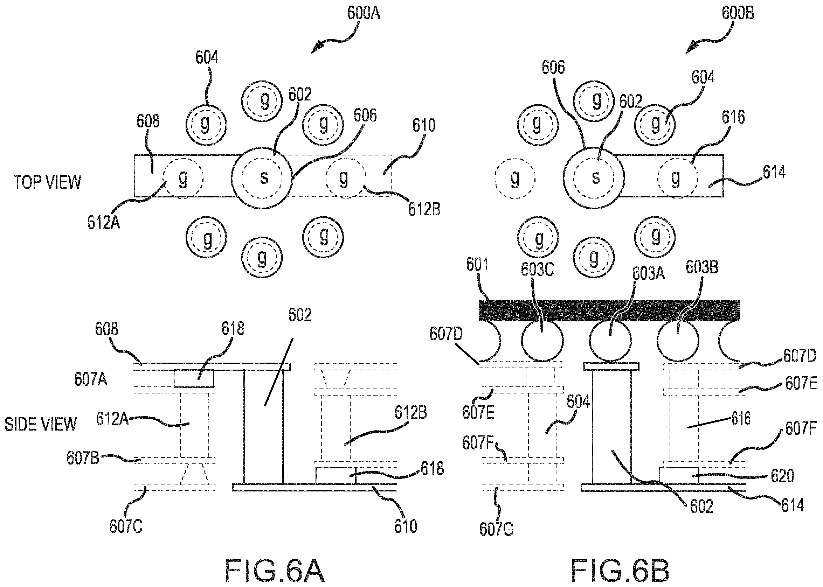

The present technology achieves signal shielding using a single-lamination cycle and provides performance as the dual-lamination cycles. The present technology provides a method for forming a complete circle of fencing vias around a signal via and then removing a portion of the fencing vias where the portion of the fencing vias may interfere with an entry trace or an exit trace, such as illustrated in FIGs. 6A and 6B, FIGs. 7A-7C, and FIGs. 9A-9C.

The present technology facilitates forming a high frequency and broadband signal path from one side of a PCB or a PCB core structure to the other side of the PCB or PCB core structure by using the single-lamination cycle rather than using dual-lamination cycles, thus significantly reducing the cost and turnaround time of the PCB. Furthermore, the present technology reduces signal leaking into the PCB layer (e.g., plate waveguides), thus improving isolation and reducing insertion loss. The PCB or PCB core structures may be used for radar and 5G millimeter-wave applications.

FIG. 6A illustrates a PCB core structure removing a portion of one or more ground fencing vias that may interfere with an entry trace or an exit trace and replacing the removed material with a dielectric material on which a crossing trace can be formed in H2H transitions according to an embodiment of the present disclosure. As illustrated in FIG. 6A, a top portion is a top view of PCB core structure 600A and a bottom portion is a sectional view of PCB core structure 600A, which includes a signal via 602 surrounded by many through vias 604 as illustrated in an upper portion of FIG. 6A, which shows a top view, such as six through vias 604. PCB core structure 600A also includes a top trace 608 on one side of a PCB and a bottom trace 610 on an opposing side of the PCB. The top trace 608 and the bottom trace 610 are connected to the signal via 602. PCB core structure 600A also includes fencing via 612A under the top trace 608.

A top end of the fencing via 612A is removed to create a cavity 618, which is filled with a dielectric material. The filled cavity 618 is positioned between the fencing via 612A and the top trace 608. Cavity 618 may be formed by removing part of any of the multiple vias that may interfere with an entry trace or an exit trace. The cavity 618 may be formed with controlled depth drilling, and then filled with a dielectric material, e.g., via-fill.

PCB core structure 600A also includes fencing via 612B above the bottom trace 610. An end portion of the fencing via 612B is also removed and replaced with a dielectric material filled cavity 618 that is positioned between an end of the fencing via 612B and the bottom trace 610. In some embodiments, the filled cavity may be positioned between a trace 608 and a conductive layer 607 that connects to the fencing via 612A. The eight through vias, including six through vias 604, one fencing via 612A, and one fencing via 612B, are positioned around the signal via 602 to shield the signals.

FIG. 6B illustrates a PCB core structure removing a portion of one or more ground fencing vias that may interfere with an entry or exit trace and replacing the removed material with a dielectric material on which a crossing trace can be formed in V2H transitions according to an embodiment of the present disclosure. As illustrated in FIG. 6B, the top portion is a top view of PCB core structure 600B, and the bottom portion is a sectional view of PCB core structure 600B.

PCB core structure 600B includes a signal via 602 in a center, which is surrounded by seven through vias 604 and one fencing via 616 with a bottom portion removed. The removed portion may form a cavity 620 that is filled with a dielectric material. The filled cavity 620 is positioned between an end of the fencing via 616 and the bottom trace 614. In some embodiments, the filled cavity 620 may be between a bottom conductive layer 607F and the fencing via 616, which extends from the conductive layer 607F through conductive layer 607E to the conductive layer 607D.

PCB core structure 600B may also include a chip 601 on one side of a PCB and conductive pins 603A-C connect to chip 501. Through vias 604 may extend from a bottom conductive layer 607G through the conductive layers 607F and 607E to the top conductive layer 607D that connects to pin 603C. The conductive layers 607F and 607E may be ground layers.

PCB core structure 600B may also include a bottom trace 614 on an opposing side of the PCB. The conductive pin 603A and the bottom trace 614 are connected to the signal via 602. The eight through vias, including seven through vias 604 and one fencing via 616, are positioned around the signal via 602 to shield the signals. Pin 603B is next to pin 603A and connects to the fencing via 616.

The present technology uses a dielectric material, e.g., via filler material to fill the cavity 618 or 620. The dielectric material is independent of the PCB core construction and is substantially isotropic and preferably similar to the PCB dielectric material that is replaced and the removed portion of the via goes through. The dielectric material is often desired to be RF-friendly. The PCB material, such as FR4 and Astra ^{®} MT77, is low cost and may have the dielectric constant Dk ranging from 2.0 to 5.0 and a loss tangent Df less than 0.01. FR4 is a printed circuit board base material made from a flame-retardant epoxy resin and glass fabric composite. FR stands for flame retardant. Astra ^{®} MT77 is a laminate material from Isola Group have been designed for commercial RF/microwave printed circuit designs.

In some aspects, the dielectric filling material (e.g., "via filler" material) may have a dielectric constant Dk ranging from 2.0 to 5.0 and a loss tangent Df less than 0.01. It may be advantageous to use a dielectric filler material with a Dk similar to that of the PCB material into which the dielectric filler mater fills such as to make the transition of the trace 608, 610, or 614 from the PCB material to the dielectric filler material and back to PCB material as continuous as possible.

In some aspects, the dielectric filler may have Dk less than or equal to that of the core.

### Shielding Structure I-Multiple Ground Vias Using A Single-Lamination Cycle

FIG. 7A illustrates an exploded perspective view of a via-fencing construction with cavities formed by removing part of multiple ground vias that may interfere with an entry or exit trace using a single-lamination cycle according to an embodiment of the present disclosure. FIG. 7B illustrates a side view of the via-fencing construction of FIG. 7A using a single-lamination cycle according to an embodiment of the present disclosure. FIG. 7C illustrates atop view of the via-fencing construction of FIGs.7A and 7B using a single-lamination cycle according to an embodiment of the present disclosure.

As illustrated in FIGs.7A-C, PCB core structure 700 may include a signal via 713 formed at a central point and extending from a first conductive layer 711 near a bottom to an Nth conductive layer 702 near a top, where N is an integer, for example, equal to four. PCB core structure 700 may also include multiple ground vias 707 that may be placed around the signal via 713 at the central point. The multiple ground vias 707 may be close enough to each other relative to the signal wavelength to reduce evanescent fields, and thus to form an effective shield and ground reference for impedance control.

PCB core structure 700 includes multiple layers. The bottom has the first conductive layer 711 and the top has an Nth conductive layer 702 or the fourth conductive layer. As shown, the PCB core structure 700 may include a copper-plated layer 701 for entry or exit trace on the top of the fourth conductive layer 702 or a copper film 702 for RF signals.

The PCB core structure 700 may also include an RF-friendly dielectric layer 704, which may be formed from a core, pre-preg, or combination and may or may not have cross-weaved fibers for reinforcement.

In some variations, the RF-friendly material may be substantially isotropic. The RF-friendly material may have a dielectric constant Dk ranging from 2.0 to 5.0 and a loss tangent Df less than 0.003.

The PCB core structure may also include multiple blind vias 703 (e.g., twelve blind vias) in the RF-friendly dielectric layer 704. The blind vias 703 are spaced apart from each other and surround trace 715 for shielding purposes. The PCB core structure 700 may also include an upper copper film 705 and a lower copper film 710 as ground.

The PCB core structure 700 may also include a middle generic dielectric layer 706 between the upper copper film 705 and the lower copper film 710. The middle generic dielectric layer 706 may be formed of a generic dielectric material.

In some aspects, the generic dielectric material may be PCB material, such as FR4, which is low cost and may have the dielectric constant Dk ranging from 3.5 to 5.0 and the loss tangent Df greater than 0.005.

The PCB core structure 700 may also include a lower dielectric layer 716 between the first conductive layer or copper film 711 for signals and the lower copper film 710, and a plated copper layer 712 under the copper film 711 for outer circuits including entry or exit pads. The chip may include entry or exit pad 714 in the plated copper layer 712. Multiple copper-plated ground through vias 707 (e.g., eight ground vias) may extend from the first conductive layer 711 to the 4th (e.g., Nth) conductive layer 702 through the middle generic dielectric layer 706, the lower dielectric layer 716, and the upper RF-friendly dielectric layer 704. In this example, N is equal to 4.

The multiple ground vias 707 may extend from the first conductive layer 711 to the top Nth conductive layer 702 through the second conductive layer 710 (e.g., ground layer), the lower dielectric layer 716, the middle generic dielectric layer 706, the third (e.g., (N-1)th) conductive layer 705 (e.g., ground layer), and the RF-friendly dielectric layer 704. In this example, N is equal to 4.

The upper RF-friendly dielectric layer 704 and the lower dielectric layer 716 may also be referred to as outer layers in the PCB core construction. In some aspects, the lower dielectric layer is formed of a generic dielectric material. In some aspects, the lower dielectric layer is formed of an RF-friendly dielectric material. For example, a dielectric layer having a trace on its top may be an RF-friendly dielectric layer. As illustrated in FIG. 5A, both outer layers 511 may be an RF-friendly dielectric layer. However, as illustrated in FIG. 5B, only the bottom outer layer 513 between conductive layer 507 and conductive layer 510 may be an RF-friendly dielectric layer.

It will be appreciated by those skilled in the art that the dimensions of the features in the present technology may be adapted to the dielectric constant Dk of the dielectric material used.

The RF-friendly material may be substantially isotropic. The RF-friendly material may have a dielectric constant Dk ranging from 2.0 to 5.0 and a loss tangent Df less than 0.003.

The coaxial shield implementation and center signal via all pass through the generic PCB material(s) used in the middle and as such inherit its dielectric constant Dk and loss tangent Df. As such, the mmWave signal transition is designed to fit the specific selection of materials making up the generic dielectric composite.

In some variations, from a performance point of view, it is desirable to have RF-friendly materials making up the generic core.

In some variations, from a cost point of view, it is desirable to have low-cost materials making up the generic core, such as FR4, which is not an RF-friendly dielectric material.

In some aspects, the generic dielectric material may be PCB material, such as FR4, which is low cost and may have the dielectric constant Dk ranging from 2 to 5.0 and the loss tangent Df greater than 0.005.

In some aspects, the dielectric filling material (e.g., "via filler" material) may have a dielectric constant Dk ranging from 2.0 to 5.0 and a loss tangent Df less than 0.005.

For the multiple vias implementation as a shield, the signal travels through the dielectric material, such as inner PCB material. Thus, the dielectric material or inner PCB material may have Dk ranging from 2.0 to 5.0. In some variations, the dielectric material or inner PCB material may have Dk ranging from 3.5 to 4.2. In some variations, the dielectric material may have a loss tangent Df less than 0.005. In some variations, the dielectric material may have a loss tangent Df less than 0.003.

In some aspects, the RF-friendly dielectric layers are core layers as opposed to pre-pregs or combinations, since the core layers are typically more uniform or isotropic than the pre-pregs or combinations.

Also, controlled depth drilled vias 709 (e.g., two controlled depth drilled and filled vias) may extend from the first conductive layer to the third or Nth-1 conductive layer 705.

Cavities may be formed above the controlled depth drilled vias 709. For example, two cavities 719 may be formed in the Nth conductive layer 702 may be formed by removing part of any of the multiple ground vias 707 that may interfere with entry traces or exit traces 715 formed from the copper-plated layer 701. The cavities 719 are represented by the larger circle around the ground via 707. The cavities 719 may be formed by controlled depth drilling and then filled with an RF-friendly dielectric material. As such, a continuous dielectric layer is formed from the filled cavities 719 and the RF-friendly dielectric layer 704. The conductive layer 701, such as copper, may be formed by plating on the continuous dielectric layer to add to the PCB core. Finally, the outer circuitry including trace 715 may be etched from the plated conductive layer 701 on the top of the PCB core.

In some aspects, the number of ground vias is equal to or greater than six. In some aspects, the number of ground vias is equal to or greater than eight. In some aspects, the number of ground vias is equal to or greater than ten.

It will be appreciated by those skilled in the art that the number of ground vias, the size of the ground vias, and the pattern of the arrangement of the ground vias may vary. It will also be appreciated by those skilled in the art that copper is used as an example and may be replaced by other conductive materials or metals.

FIGs. 8A-8G are diagrams illustrating operations for forming the first via-fencing construction of FIGs.7A-7C using a single-lamination cycle according to an embodiment of the present disclosure. As illustrated in FIG. 8A, method 800 may include providing an etched and laminated PCB core structure including RF layer(s) at operation 801. All layers for the shield construction are prepared together in a single-lamination cycle to form a complete PCB core structure 811. The single-lamination cycle replaces the second lamination cycle with a cheaper operation of dielectrically filling a cavity, and thus has a lower cost than the dual-lamination cycles.

As illustrated in FIG. 8B, method 800 may also include drilling to form through vias 707 and also blind vias 703 at operation 802. As illustrated in FIG. 8C, method 800 may also include plating the through vias 707 and blind vias 703 at operation 803.

As illustrated in FIG. 8D, method 800 may also include forming two cavities 719 by controlled depth drilling through vias 707 from layer N to layer N-1 at operation 804. The two cavities 719 may also be referred to as removed portions of one or more through vias. The cavities may be filled with a dielectric material, such as an RF-friendly dielectric material. As illustrated in FIG. 8E, method 800 may also include filling the cavities and the through vias 707 at operation 805.

As illustrated in FIG. 8F, method 800 may also include panel plating one or more sides of the PCB core structure 811 to form a plated layer 701 at operation 806. As illustrated in FIG. 8G, method 800 may also include forming outer circuits including trace 715 by etching the plated layer 701 at operation 807. Because of the cavities formed, trace 715 can cross over the through vias which may otherwise obstruct the trace.

### Shielding Structure II-Coaxial Implementation Using A Single-Lamination Cycle

The present technology laminates all layers needed for the construction in a single-lamination cycle to form a PCB core structure. FIG. 9A illustrates an exploded perspective view of a coaxial construction with cavities formed by removing part of an outer shell of a large via that may interfere with an entry or exit trace using a single-lamination cycle according to an embodiment of the present disclosure. FIG. 9B illustrates a side view of the coaxial construction of FIG. 9A using a single-lamination cycle according to an embodiment of the present disclosure. FIG. 9C illustrates a top view of the coaxial construction of FIGs. 9A and 9B using a single-lamination cycle according to an embodiment of the present disclosure.

PCB core structure 900 may include a signal via 908 formed at the central point from the first conductive layer 910 to the Nth conductive layer 902 or the fourth conductive layer, where N is equal to 4. The signal via 908 may be copper-plated.

PCB core structure 900 may also include a large via or outer shell via 907 which has an outer shell 914 coaxial with the inner signal via 908 and extends from a first conductive layer 910 to the Nth conductive layer 902. The outer shell is also referred to as an outer coaxial shell or outer coax shell. The outer shell 914 of the large via or outer shell via 907 is partly removed to create cavity 915, which is represented by a small circle that shifts down from the outer shell via 907. The outer shell 914 may include a first segment 914A between intersection points 919A and 919B, which may extend from the first conductive layer 910 to the Nth conductive layer 902. The outer shell 914 may also include a second segment 914B between intersection points 919A and 919B. The second segment 914B points to cavity 915. The second segment 914B overlaps with trace 913 as illustrated in FIG. 9C. As such, the second segment 914B may extend from the first conductive layer 910 to the (N-1)th conductive layer 905, and thus may not interfere with or short the entry or exit traces 913.

The cavity 915 may be formed by controlled depth drilling of the Nth conductive layer 902. The cavity 915 may be circular and is off-centered from the signal via 913. Cavity 915 has intersection points 919A and 919B with the outer shell 914. The second segment 914B of the outer shell 914 is formed with the controlled depth drilling through the conductive layer 902. The cavity 915 may then be filled with a dielectric material such that a continuous dielectric layer is formed from an RF-friendly dielectric layer 904 to extend into the conductive layer 902.

FIG. 9D illustrates a PCB core structure including the coaxial construction of FIGs. 9A-9C removing a portion of a coaxial outer shell that may interfere with an entry/exit trace and replacing the removed material with a dielectric material on which a crossing trace can be formed in H2H transitions according to an embodiment of the present disclosure. FIG. 9E is similar to FIG. 6A, except that FIG. 9D uses coaxial construction for shielding. A first cavity 915A removes a portion of the outer shell 907 at a controlled depth from the top and is filled with the dielectric material. A second cavity 915B removes a portion of the outer shell 907 at a controlled depth from the bottom and is filled with the dielectric material. The conductive layers 901, 905, and 909 are interleaved with dielectric layers 904, 906, and 916. A top trace 913A connects to the top of the inner signal via 908. A bottom trace 913B connects to the bottom of the inner signal via 908.

FIG. 9E illustrates a PCB core structure including the coaxial construction of FIGs. 9A-9C removing a portion of a coaxial outer shell that may interfere with an entry or exit trace and replacing the removed material with a dielectric material on which a crossing trace can be formed in V2H transitions according to an embodiment of the present disclosure. FIG. 9D is similar to FIG. 6B, except that FIG. 9E uses coaxial construction for shielding. Cavity 915B removes a portion of the outer shell 907 at a controlled depth from the bottom and is filled with the dielectric material. The bottom trace 913B connects to the bottom of the inner signal via 908.

The upper dielectric layer 904 and the lower dielectric layer 916 are also referred to as outer layers in the PCB core structure 900.

Outer circuitry including entry trace or exit trace 913 may be formed over the continuous dielectric layer by etching. By using controlled depth milling, a plated-filled outer shell via 907 is partly removed, such that a connection is formed from the trace 913 to an inner via or the signal via 908 without shorting to the outer shell via 907.

PCB core structure 900 has multiple layers. The bottom has the first conductive layer 910 and the top has the Nth conductive layer 902 for RF signals, where N is equal to 4. As shown, the PCB core structure 900 may include a copper-plated layer 901 that is etched to form entry or exit traces 913 for the RF signals on the top of the Nth conductive layer 902. The PCB core structure 900 may also include an RF-friendly dielectric layer 904 in which multiple blind vias 903 (e.g., twelve blind vias) are spaced apart from each other and surround the entry or exit traces 913. The multiple blind vias 903 are also referred to as shielding micro vias for the signal via 908. The PCB core structure 900 may also include an upper copper film 905 and a lower copper film 909 as ground layers. The PCB core structure 900 may also include a middle generic dielectric layer 906 between the upper copper film 905 and the lower copper film 909.

The PCB core structure 900 may also include a lower dielectric layer 916 between the lower copper film 911 for signals and the copper film 910, and a plated copper layer 911 for outer circuits including entry or exit pad 912. A chip may include the entry or exit pad 912.

The signal via 908 and large via 907 may extend from the first conductive layer 910 to the Nth or fourth conductive layer 902 through the lower dielectric layer 916, the middle generic dielectric layer 906, and the upper RF-friendly dielectric layer 904.

In some variations, the PCB core structure may not need mode suppression/shielding vias on the top layers around the inner via or signal via, since the outer shell via goes all the way to the top, except where a portion of the outer shell via is removed for the exit trace 913. For the coaxial implementation, blind vias may not be needed as the outer coax shell forms a continuous shield around the signal transition on the exterior layers such as entry trace or exit trace.

The PCB core structure 900 can be formed using a single-lamination cycle for the PCB, which is more cost-effective than achieving similar structures using dual-lamination cycles. Again, the single-lamination cycle has a lower cost than the dual-lamination cycle by replacing the second lamination cycle with a low-cost operation of dielectrically filling a cavity.

The PCB core structure 900 may be formed by first forming a PCB core assembly from the middle dielectric layer(s) 906 with any desired metallization layers within and the upper RF-friendly dielectric layer 904 and the lower dielectric layer 916, each with substantially continuous ground planes 905 and 909 facing towards the inner layers. The outer coax shell 907 is then formed from top to bottom, metal-plated and dielectric material filled. Cavity 905 is formed by removing a part of the outer shell down to the nearest ground plane and cavity 905 is then filled with an RF-friendly dielectric material. Followed by forming the inner via 908 and the chip entry/exit pad 912 and the chip exit/entry trace 913 to the inner via 908 and the blind vias 903 or shielding micro vias around the inner via 908. The present technology uses a dielectric material, e.g., via filler material to fill the outer shell via 907. The dielectric material is independent of the PCB core construction and may be substantially isotropic. Being independent of the PCB core construction means that the performance is independent of variations in dielectric constant Dk from layer to layer of the PCB core structure and independent of the number of layers and thus allows for a single design fitting multiple PCB core build.

FIGs. 10A-10K are diagrams illustrating operations for forming the coaxial construction of FIGs. 9A-9C using a single-lamination cycle according to an embodiment of the present disclosure. As illustrated in FIG. 10A, method 1000 may include providing an etched and laminated PCB core structure including RF layer(s) at operation 1001. All layers for the shield construction are prepared together in a single-lamination cycle to form a complete PCB core structure 1012.

As illustrated in FIG. 10B, method 1000 may also include drilling to form an outer coaxial shell 914 in the core structure 1012 at operation 1002. As illustrated in FIG. 10C, method 1000 may also include plating the outer coaxial shell 914 at operation 1003. As illustrated in FIG. 10D, method 1000 may also include filling the plated outer coaxial shell 914 with a dielectric material at operation 1004. It is desirable to use an RF-friendly material to fill the outer shell via. In other words, the dielectric material may be an RF-friendly material.

As illustrated in FIG. 10E, method 1000 may also include forming a cavity 915 by controlled depth drilling part of the outer coaxial shell 914 at operation 1005. Cavity 915 may be filled with a dielectric material. As such, trace 913 can cross over the outer shell 914 which may otherwise obstruct trace 913. As illustrated in FIG. 10F, method 1000 may also include filling the controlled depth drilled cavity 915 with a dielectric material at operation 1006. The dielectric material may be an RF-friendly dielectric material.

As illustrated in FIG. 10G, method 1000 may also include drilling to form a signal via 908 and blind vias 903 at operation 1007. As illustrated in FIG. 10H, method 1000 may also include plating the signal via 908 and blind vias 903 with a metal (e.g., copper) at operation 1008. As illustrated in FIG. 101, method 1000 may also include filling the plated signal via 908 and plated blind vias 903 with a dielectric material at operation 1009. The dielectric material may be a generic dielectric material.

As illustrated in FIG. 10J, method 1000 may also include panel plating on one or more sides of the PCB core 1012 to form a plated layer 901 at operation 806. As illustrated in FIG. 10K, method 1000 may also include forming outer circuits including trace 913 by etching the plated layer at operation 1011.

It is understood that variations may exist including variations in the number of ground vias forming the shield, off-center location of the central signal via, filled versus unfilled vias, among others, variations using interconnect materials to allow for using cores for the RF layer(s) instead of pre-preg and core combination.

Variations may include, but are not limited to, forming the large via, then the cavity, and filling both at the same time, which saves a step but may introduce metal or dielectric burrs.

Variations may also include, but are not limited to, the introduction of planarization to flatten the dielectric filler material.

Variations may also include, but are not limited to, the introduction of copper thinning to reduce excessive copper thickness leading to larger etch tolerances.

Variations may also include, but are not limited to, off-center central via and non-circular outer shell/fence shapes.

Variations may also include, but are not limited to, multiple signal vias inside the shell/fence e.g., differential signaling.

It will be appreciated by those skilled in the art that variations in the number of ground vias forming the shield, off-center location of the central signal via, and filled versus un-filled vias, among others.

The present technology provides electrical benefits, including (a) limited leakage or no leakage into PCB core layers, (b) broadband (e.g., 0 to 90 GHz), and (c) approximately 50 ohms throughout, thus avoiding potential signal super positioning depending on layout and tolerances.

The present technology also provides mechanical benefits, including an outer coaxial shell or cluster of ground vias being visible when drilling the center signal via, which allows for easy visual alignment resulting in tighter tolerances.

The present technology also provides system benefits. For example, the coaxial implementation is more compact than other controlled impedance solutions, which makes a tight pitch possible and thus allows for small chips.

The present technology also reduces costs associated with a second lamination cycle. The present technology also reduces cost by the tight pitch, which can result in low system cost, e.g., small dies in the chips, and small PCB.

### Examples

The following examples are for illustration purposes only. It will be apparent to those skilled in the art that many modifications, both to materials and methods, may be practiced without departing from the scope of the disclosure.

### Example 1- Return Loss and Insertion Loss of Various Via Shielding Structures

Various methods can be used for forming a signal transition from one side of a PCB to the other side of the PCB for use with broadband and high-frequency signals (e.g., mmWave). The shielding structures I and II as disclosed above have better performances than the partial via shielding structure III using a single lamination, and lower cost that shielding structures IV, and V using dual-lamination cycles as disclosed below.

### Shielding Structure III-Partial Via-fencing Using A Single-Lamination Cycle

The following PCB core is fabricated by preparing and laminating all layers needed for the construction in a single-lamination cycle. FIG. 11A illustrates an exploded perspective view of a partial via-fencing construction using a single-lamination cycle according to an embodiment of the present disclosure. FIG. 11B illustrates a side view of the partial via-fencing construction of FIG. 11A using a single-lamination cycle according to an embodiment of the present disclosure. FIG. 11C illustrates a top view of the partial via-fencing construction of FIGs. 11A-11B using a single-lamination cycle according to an embodiment of the present disclosure.

As illustrated, a PCB core structure 1100 may include a signal via 1116 extending from a conductive layer 1111 to the Nth conductive layer 1102 for RF signals. The signal via 1116 may be formed in the center of six ground vias 1110, which function to shield signals in the signal via 1116 and to maintain a controlled impedance for the signal via 1116. The six ground vias 1116 may be placed close enough to each other relative to the minimum signal wavelength to minimize evanescent fields.

Similar to the PCB core structure 700, the PCB core structure 1100 may include multiple layers. The bottom has a copper film 1111 for signals and the top has a copper film 1102 for RF signals. As shown, the PCB core structure 1100 may include a copper-plated layer 1101 for entry or exit trace 1114 on the top of the copper film 1102 for RF signals. The PCB core structure 1100 may also include an RF-friendly dielectric layer 1104 in which multiple blind vias 1103 (e.g., twelve blind vias) are spaced apart from each other and surround trace 1114 for shielding purposes. The PCB core structure 1100 may also include an upper copper film 1105 and a lower copper film 1109 as ground layers.

The PCB core structure 1100 may also include a middle generic dielectric layer 1106 between the upper copper film 1105 and the lower copper film 1109. The PCB core structure 1100 may also include a lower dielectric layer 1118 between the bottom copper film 1111 for signals and the ground copper film 1109, and a plated copper layer 1112 under the copper film 1111 for outer circuits including entry or exit traces or pads 1115. A chip may include entry or exit pad 1115 in the plated copper layer 1112. Multiple copper-plated ground through vias 1110 (e.g., six ground vias) may extend from the bottom copper film 1111 to the top copper film 1102 through the middle generic dielectric layer 1106, the lower dielectric layer 1118, and the upper RF-friendly dielectric layer 1104.

The upper dielectric layer 1104 and the lower dielectric layer 1118 may be metalized cores when the inner structure has pre-pregs at the outside, or the outer layers 1104 and 1118 may be pre-pregs when the inner structure does not have pre-pregs on the outside. The outer layers are preferably metalized cores for radio frequency (RF) and mmWave circuits due to better consistencies than the pre-preg and for better selection of low loss film metallization.

However, at the entry and exit of the signal on the exterior layers, there cannot be any ground vias, as shown in FIG. 11C, leading to significant leakage/coupling of the signal into the core of the PCB, e.g., a typically non-RF portion of PCB, which leads to losses and crosstalk. As such, the PCB core structure 1100 includes a partial via-fencing implementation because there are no ground vias in region 1117 in which copper rings 1107 and 1108 partially overlap with entry or exit trace 1114, as illustrated in FIG. 11C. The PCB core structure 1100 may also include copper rings or planes 1107 and 1108 inserted within the generic dielectric layer 1106 to reduce the leakage and improve impedance control. The PCB core structure 1100 may also include blind vias 1106 for shielding the entry or exit trace 1114.

FIGs. 12A-12F are diagrams illustrating operations for forming the partial via-fencing construction of FIGs. 11A-11C using a single-lamination cycle starting from a laminated core construction according to an embodiment of the present disclosure.

As illustrated in FIG. 12A, method 1200 may include etching core layers and laminating all layers in a single lamination cycle at operation 1201. As illustrated in FIG. 12B, method 1200 may also include drilling a signal via 1116, multiple ground vias 1110, and multiple blind vias 1103 at operation 1202. As illustrated in FIG. 12C, method 1200 may also include plating the signal via 1116, multiple ground vias 1110, and multiple blind vias 1103 with a metal (e.g., cooper) to form plated signal via, plated ground vias, and plated blind vias at operation 1203. As illustrated in FIG. 12D, method 1200 may also include filling the plated signal via 1116, the plated multiple ground vias 1110, and the plated blind vias 1103 with a dielectric material at operation 1204. The dielectric material may be a generic dielectric material.

As illustrated in FIG. 12E, method 1200 may also include panel plating one or more sides of the PCB core 1210 to form a plated layer 1101 at operation 1205. As illustrated in FIG. 12F, method 1200 may also include forming outer circuits including trace 1114 by etching the plated layer at operation 1206.

The single-lamination cycle is low cost, as it requires no special PCB processing over a standard PCB board. However, the performance of the partial via-fencing implementation of FIGs. 11A-11C may be poor and may be highly dependent on the inner core materials of the PCB.

### Shielding Structure IV-Complete Circle Via-fencing Using Dual-Lamination Cycles

The following discloses fabricating a complete circle via-fencing implementation by using dual-lamination cycles. First, an inner core is formed, excluding trace entry/exit layers in one lamination. In the inner core, vias are formed under where the entry or exit trace may run at a distance away from a central point. Then, the exterior layer(s) that have entry or exit traces are added to the inner core in a second lamination cycle. The exterior layers may be added in the form of a pre-preg and a core layer to either one side or two opposite sides such that they can be formed directly on the exterior copper of the inner core. Multiple ground vias are placed around the central point to complete the via circle started by the core fencing vias, close enough to each other relative to the minimum signal wavelength to minimize evanescent fields and thus forming a complete and effective shield and ground reference for impedance control. A central signal via is then added and the appropriate entry or exit traces are formed.

The complete circle via implementation by the dual-lamination cycles has less leakage than the partial via-fencing implementation by the single lamination cycle but is quite a bit more expensive due to the second lamination cycle required.

FIG. 13A illustrates an exploded perspective view of a via-fencing construction using dual-lamination cycles according to an embodiment of the present disclosure. FIG. 13B illustrates a side view of the via-fencing construction of FIG. 13A using dual-lamination cycles according to an embodiment of the present disclosure. FIG. 13C illustrates a top view of the via-fencing construction of FIGs. 13A-13B using dual-lamination cycles according to an embodiment of the present disclosure.

As illustrated, a PCB core structure 1300 may include a signal via 1316 extending from a first conductive layer 1311 near the bottom to the Nth conductive layer 1302 near the top for RF signals, where N is 4 in this example. The signal via 1316 may be formed in the center of six ground vias 1310 and two buried vias 1313, which function to shield signals in the signal via 1316 and to maintain a controlled impedance for the signal via 1316. The six ground vias 1316 may be placed close enough to each other relative to the minimum signal wavelength to minimize evanescent fields. The two buried vias 1313 may extend from the first conductive layer 1311 to the (N-1)th conductive layer 1305.

Similar to the PCB core structure 700, the PCB core structure 1300 may include multiple layers. The bottom has the first conductive layer (e.g., copper film) 1311 for signals and the top has the Nth conductive layer (e.g., copper film) 1302 for RF signals. As shown, the PCB core structure 1300 may include a copper-plated layer 1301 for entry or exit trace 1314 on the top of the copper film 1302 for RF signals. The PCB core structure 1300 may also include an RF-friendly dielectric layer 1304 in which multiple blind vias 1303 (e.g., twelve blind vias) are spaced apart from each other and surround trace 1314 for shielding purposes.

The PCB core structure 1300 may also include an upper copper film 1305 and a lower copper film 1309 as ground layers. The PCB core structure 1300 may also include a middle generic dielectric layer 1306 between the upper copper film 1305 and the lower copper film 1309.

The PCB core structure 1300 may also include a lower dielectric layer 1318 between the bottom copper film 1311 for signals and the ground copper film 1109, and a plated copper layer 1312 under the copper film 1311 for outer circuits including entry or exit traces or pads 1315. The chip may include entry or exit pad 1315 in the plated copper layer 1312. Multiple copper-plated ground through vias 1310 (e.g., six ground vias) may extend from the bottom copper film 1311 to the top copper film 1302 through the middle generic dielectric layer 1306, the lower dielectric layer 1318, and the upper RF-friendly dielectric layer 1304. The upper RF-friendly dielectric layer 1304 and the lower dielectric layer 1318 may be referred to as outer layers in the PCB core construction.

In some aspects, the lower dielectric layer may be formed of a generic dielectric material. In some aspects, the lower dielectric layer may be formed from an RF-friendly dielectric material. The outer layer(s) 1304 and 1313 are preferable core layers due to better consistencies than pre-pregs or combinations.

The PCB core structure 1300 may also include copper rings or planes 1307 and 1308 inserted within the middle generic dielectric layer 1306 to reduce the leakage and improve impedance control. The PCB core structure 1300 may also include blind vias 1303 for shielding the entry or exit trace 1314.

Dual-lamination cycles are used for forming a complete via-fencing construction. FIGs. 14A-14K are diagrams illustrating operations for forming the complete via-fencing construction of FIGs. 13A-13C using dual-lamination cycles starting from a laminated core construction according to an embodiment of the present disclosure. As illustrated in FIG. 14A, method 1400 may include etching core layers and laminating the layers to form an inner core 1412 at operation 1401. In the first lamination cycle, the inner core 1412 is formed.

As illustrated in FIG. 14B, method 1400 may include drilling buried vias 1313 in the inner core 1412 at operation 1402. As illustrated in FIG. 14C, method 1400 may include plating the buried vias 1313 in the inner core 1412 at operation 1403. As illustrated in FIG. 14D, method 1400 may include filling the buried vias 1313 in the inner core 1412 with a dielectric material at operation 1404. The dielectric material may be a generic dielectric material. As illustrated in FIG. 14E, method 1400 may include etching layer N-1 of the inner core 1412 at operation 1405.

As illustrated in FIG. 14F, method 1400 may include laminating RF layer 1415 onto the core 1412 in a second lamination cycle at operation 1406. As illustrated in FIG. 14G, method 1400 may include drilling a signal via 1316 and ground vias 1310 through the RF layer 1415 and the inner core 1412 and drilling blind vias 1303 in the RF layer 1415 at operation 1407. As illustrated in FIG. 14H, method 1400 may include plating the signal via, ground vias, and blind vias at operation 1408. As illustrated in FIG. 14I, method 1400 may include filling the plated signal via, ground vias, and blind vias with a dielectric material at operation 1409.

In the second lamination cycle, the exterior RF layer 1415 in the form of pre-preg may be added to the inner core 1412. The signal via 1316 is formed in a center and surrounded by multiple through-ground vias 1310. The blind vias 1303 are positioned near the entry or exit trace 1314. The multiple ground vias 1310 are placed around the signal via 1316 to form an effective shield (e.g., via-fencing) relative to the wavelength of the signal and facilitate a controlled impedance for the signal via, and thus form a shielded signal transition that may not leak much into the PCB core layers. However, the second lamination cycle significantly adds cost. Also, the performance may be dependent on the inner core materials.

As illustrated in FIG. 14J, method 1400 may also include panel plating on one side of the PCB core including the RF layer 1415 to form a plated layer 1301 at operation 1410. As illustrated in FIG. 14K, method 1400 may also include forming outer circuits including trace 1314 by etching the plated layer at operation 1411.

### Shielding Structure V-Coaxial Constructive Using Dual-Lamination Cycles

The following section discloses the fabrication of a coaxial construction using dual-lamination cycles. First, an inner core is formed in which a large diameter via is formed. The large diameter via is then filled with a dielectric. The exterior layers in the form of a pre-preg and a core layer are added. Then, the central signal via is formed in the middle of the filled large-diameter via. The large-diameter via and the central via form a coaxial structure. Blind vias or micro vias are formed to function as a fence or shield in the exterior layers, except near the entry and exit traces. The coaxial signal transition prevents any leakage into the core PCB layers. The outer coaxial shield (e.g., large-diameter via) and the dielectric that fills the large-diameter via make the structure performance independent of the materials in the inner core of the PCB.

FIG. 15A illustrates an exploded perspective view of a coaxial construction using dual-lamination cycles according to an embodiment of the present disclosure. FIG. 15B illustrates a side view of the coaxial construction of FIG. 15A using dual-lamination cycles according to an embodiment of the present disclosure. FIG. 15C illustrates a top view of the coaxial construction of FIGs. 15A-15B using dual-lamination cycles according to an embodiment of the present disclosure.

As illustrated, PCB core structure 1500 includes multiple layers. The PCB core structure 1500 includes a large via having an outer shell 1507 at a central point to form the outer shield of a coaxial structure. The large via is then filled with a dielectric material. Then, the exterior layer 1504 is added to the core in a second lamination cycle. The exterior layer 1501 includes entry or exit traces 1514. An exterior layer 1504 is added in the form of a pre-preg and a core layer, such that it can be formed directly on the exterior copper 1505 of the core. A signal via 1508 and blind vias 1507 for fencing are then added to the PCB core structure 1500 and entry or exit traces 1514 are formed on the top, as illustrated in FIGs. 15A-15C. The coaxial implementation using dual-lamination cycles may not have any leakage into the central core layers. The performance may be independent of the core layer materials. However, the dual-lamination cycles are expensive due to the second lamination cycle.

A PCB core structure 1500 may include a signal via 1508 formed at the central point from the first conductive layer 1510 to the Nth conductive layer 1502 or fourth conductive layer, where N is equal to 4. The signal via 1508 may be copper-plated.

The PCB core structure 1500 may also include a large via 1507 which has an outer shell 1514 coaxial with the inner signal via 1508 and extends from a first conductive layer 1510 to the Nth conductive layer 1502. The outer shell 1514 of the large via 1507 is partly removed to extend from the first conductive layer 1510 to the (N-1)th conductive layer 1505 to form partly buried outer coaxial shell 1512, and thus may not interfere with or short the entry or exit traces 1513.

The PCB core structure 1500 has multiple layers. The bottom has the first conductive layer 1510 and the top has the Nth conductive layer 1502 for RF signals, where N is equal to 4. As shown, the PCB core structure 1500 may include a copper-plated layer 1501 that is etched to form entry or exit traces 1513 for the RF signals on the top of the Nth conductive layer 1502. The PCB core structure 1500 may also include an RF-friendly dielectric layer 1504 in which multiple blind vias 1503 (e.g., twelve blind vias) are spaced apart from each other and surround the entry or exit traces 1513. The PCB core structure 1500 may also include an upper copper film 1505 and a lower copper film 1509 as ground layers. The PCB core structure 1500 may also include a middle generic dielectric layer 1506 between the upper copper film 1505 and the lower copper film 1509.

The PCB core structure 1500 may also include a lower dielectric layer 1516 between the lower copper film 1511 for signals and the copper film 1510, and a plated copper layer 1511 for outer circuits including entry or exit pad 1514. The chip may include the entry or exit pad 1514.

The signal via 1508 and large via 1507 may extend from the first conductive layer 910 to the Nth or fourth conductive layer 1502 through the lower dielectric layer 1516, the middle generic dielectric layer 1506, and the upper RF-friendly dielectric layer 1504.

FIGs. 16A-16J are diagrams illustrating operations for forming the coaxial construction of FIGs. 15A-15C using dual-lamination cycles according to an embodiment of the present disclosure. As illustrated in FIG. 16A, method 1600 may include etching core layers and laminating the layers in a first lamination cycle at operation 1601. In the first lamination cycle, an inner core 1611 is formed.

As illustrated in FIG. 16B, method 1600 may also include drilling partly buried outer coaxial shell 1512 in the core 1611 at operation 1602. As illustrated in FIG. 16C, method 1600 may also include plating the partly buried outer coaxial shell 1512 in the core at operation 1603. As illustrated in FIG. 16D, method 1600 may also include filling the plated partly buried outer coaxial shell 1512 in the core with a dielectric material at operation 1604.

As illustrated in FIG. 16E, method 1600 may include laminating RF layer 1504 onto the core 1611 in a second lamination cycle at operation 1605. The partly buried outer coaxial shell 1512 does not extend into the RF layer 1504 and is placed around the signal via 1508 to form an effective shield of the signal and to facilitate a controlled impedance for a subsequently formed central signal via, and thus form a shielded signal transition that may not leak much into the PCB core layers.

As illustrated in FIG. 16F, method 1600 may also include drilling a signal via 1508 and blind vias 1503 in the core at operation 1606. The signal via is coaxial with the outer coaxial shell 1512. As illustrated in FIG. 16G, method 1600 may also include plating the signal via and blind vias in the core at operation 1607. As illustrated in FIG. 16H, method 1600 may also include filling the plated signal via and blind vias in the core with a dielectric material at operation 1408.

In the second lamination cycle, an RF layer or RF dielectric layer 1504 is added to the core 1611. The RF layer may be formed from a pre-preg or a pre-preg and core layer. A conductive layer is then deposited over the RF layer 1504. The RF layer may include the conductive layer over the dielectric layer when the dielectric is formed using a pre-preg and a core. The RF layer may not include the conductive layer when the dielectric is formed from pre-preg alone. Then, the signal via 1508 is formed in a center and surrounded by outer coaxial shell 1512 and blind vias 1503 near the entry or exit traces 1513. However, the second lamination cycle significantly increases the cost of fabrication.

As illustrated in FIG. 16I, method 1600 may also include panel plating on one side of the PCB core including the RF layers 1504 to form a plated layer 1501 at operation 1609. It will be appreciated by those skilled in the art that the panel plating may be applied to another side of the PCB core. As illustrated in FIG. 16J, method 1600 may also include forming outer circuits including trace 1513 by etching the plated layer at operation 1610.

In some aspects, a waveguide transition may be used. The waveguide transition is band-limited and may not extend to DC.

FIG. 17A illustrates return loss versus frequency for various shield signal vias according to an embodiment of the present disclosure. Curves 1702A, 1702B, 1702C, 1702D, and 1702E represent return loss versus frequency for shielding structures I, II, III, IV, and V, respectively.

FIG. 17B illustrates insertion loss versus frequency for various shield signal vias according to an embodiment of the present disclosure. Curves 1704A, 1704B, 1704C, 1704D, and 1704E represent insert loss versus frequency for shielding structures I, II, III, IV, and V, respectively.

As illustrated in FIGs. 17A and 17B, the performance using dual-lamination cycles (e.g., shielding structures IV and V fabricated using dual-lamination cycles) is very similar to the performance using a single-lamination cycle, both for the via-fencing implementation and the coaxial implementation (e.g., shielding structures I and II fabricated using a single-lamination cycle). However, the performance of the partial via-fencing using a single-lamination cycle (e.g., shield structure III fabricated using a single-lamination cycle) is inferior to the via-fencing implementation and the coaxial implementation using a single-lamination cycle (e.g., shielding structures I and II fabricated using a single-lamination cycle).

### Example 2- Evanescent Fields

The leakage may be determined by evanescent fields in the PCB core structure. The evanescent fields refer to fields that are significantly weaker than the main fields or desired fields. FIG. 18A shows a top view and a side view of evanescent field contour lines for the partial via-fencing construction of FIGs. 11A-11C using a single-lamination cycle according to an embodiment of the present disclosure. Evanescent field contour lines 1802A may extend beyond a partial via-fencing 1800A. As illustrated, Evanescent field contour lines 1802A may extend beyond trace 1804. Evanescent field contour lines 1802A may also extend beyond a top surface 1807A and a bottom surface 1807B.

FIG. 18B shows a top view and a side view of Evanescent field contour lines for the complete circle via-fencing construction of FIGs. 13A-13C using dual-lamination cycles according to an embodiment of the present disclosure. As illustrated, Evanescent field contour lines 1802B may extend to only a portion of the trace 1804. Evanescent field contour lines 1802B may also extend beyond a top surface 1808A and a bottom surface 1808B. As such, the complete circle via-fencing 1800B may be better than the partial via-fencing 1800A for shielding purposes.

FIG. 18C shows a top view and a side view of Evanescent field contour lines for the coaxial construction of FIGs. 15A-15C using dual-lamination cycles according to an embodiment of the present disclosure. Evanescent field contour lines 1802B also extend beyond a complete circle via-fencing 1800B, but less than the partial via-fencing. As illustrated, Evanescent field contour lines 1802C may not extend beyond large via 1806. Evanescent field contour lines 1802C may also extend beyond a top surface 1809A and a bottom surface 1809B. As such, the coaxial construction 1800C may be better than the complete circle via-fencing 1800B for shielding purposes.

FIG. 19A shows a top view and a side view of Evanescent field contour lines for the via-fencing construction of FIGs.7A-C using a single-lamination cycle according to an embodiment of the present disclosure. Evanescent field contour lines 1902A also extend beyond a top surface 1907A and a bottom surface 1907B. Also, Evanescent field contour lines 1902A extend to a portion of the trace 1904.

FIG. 19B shows a top view and a side view of Evanescent field contour lines for the coaxial construction of FIGs. 9A-9C using a single-lamination cycle according to an embodiment of the present disclosure. Evanescent field contour lines 1902B also extend beyond a top surface 1908A and a bottom surface 1908B. However, Evanescent field contour lines 1902B may not extend beyond large via 1906. As such, the coaxial construction 1900B may be better than the complete circle via-fencing 1900A for shielding purposes.

As illustrated in FIGs. 19A and 19B in comparison to FIGs. 18A-18C, the present technology using a single-lamination cycle, at a lower cost, is similar to the via-fencing construction or the coaxial construction using dual-lamination cycles. The via-fencing construction (e.g., illustrated in FIGs.7A-7C) significantly outperforms the partial via-fencing construction using a single-lamination cycle (e.g., illustrated in FIGs. 11A-11C).

Table 1 lists comparisons of various shielding designs. For example, some shielding designs may have low insertion loss (IL), e.g., IL is equal to or less than 0.8 dB. Some shielding designs may have medium insertion loss (IL), e.g., IL between 0.8 dB and 1.2 dB. Some shielding designs may have high insertion loss (IL), e.g., IL equal to or greater than 1.2 dB. Some shielding designs may have narrow bandwidth (BW), e.g., BW equal to or less than 10 GHz. Some shielding designs may have medium bandwidth (BW), e.g., BW between 10 GHz and 30 GHz. Some shielding designs may have wide bandwidth (BW), e.g., BW equal to or greater than 50 GHz. It will be appreciated by those skilled in the art that the values for the bandwidths or insertion loss may vary for each characterized term "low", "medium", "high", "narrow", and "wide." Tradeoffs may be made for particular applications in a selected frequency band of operation.

**Table 1**

| Metrics | Coaxial and via cluster by single lamination (types I and II) | | Partial Via fence by single lamination (type III) | | Via fence by dual laminations (type IV) | | Coaxial construction by dual laminations (type V) | |
|---|---|---|---|---|---|---|---|---|
| | Outer Shell, Mill & Fill | Via Cluster, Mill & Fill | Few vias (<=5) | Many via's (>=6) | Pre-preg outer layers | Core outer layers | Pre-preg outer layers | Core outer layers |
| Cost | Low | Low | Lowest | Lowest | Expensive | Expensive | Most expensive | Most expensive |
| Via Leakage, crosstalk, EMI | None | Very little | Severe | Some | Very little | Mild to severe | Very little | Mild to severe |
| Stackup material dependent | No | Yes | Yes | Yes | Yes | Yes | No | No |
| Stackup layer count dependent | No | Some | Yes | Some | Some | Some | No | No |
| Bandwidth | Very wide | Medium | Narrow | Narrow | Medium | Medium | Very wide | Very wide |
| Trace neckdown required to pass between ground vias | No | No | No | Severe, at ~<=8 via's | No | No | No | No |
| Real estate required | Low | Medium | Medium | Medium | Medium | Medium | Low | Low |
| Insertion Loss | Low | Medium | High | High | Medium | Medium | Low | Medium |

### Example 3- Return loss/insertion loss for via-fencing construction with various heights

Simulation data for via in pad chip were performed. The structure, as illustrated in FIG. 1B, represents a chip to via in pad plated over (VIPPO) design to via to trace configuration. The shield structure is a coaxial implementation. The process is single lamination. Simulated total heights for multiple layers of PCBs included 1.25 mm, 1.75 mm, and 2.25 mm.

FIG. 20A shows simulated return loss versus frequency for the via-fencing construction of FIGs.7A-C with various PCB heights according to an embodiment of the present disclosure. Curves 2002A, 2002B, and 2002C represent return loss at heights 1.25 mm, 1.75 mm, and 2.25 mm, respectively. As illustrated, the return loss has a trend to increase with frequency.

FIG. 20B shows simulated insert loss versus frequency for the via-fencing construction of FIGs.7A-C with various PCB heights according to an embodiment of the present disclosure. Curves 2004A, 2004B, and 2004C represent insert loss at heights 1.25 mm, 1.75 mm, and 2.25 mm, respectively. As illustrated, the insert loss drops with increased frequency. A significant drop in insertion loss occurs near 80-90 GHz.

As illustrated in FIG. 20A and FIG. 20B, all three heights demonstrated usable bandwidth from 0 GHz to 80 GHz. These simulated results also work for the trace to via to trace configuration or H2H transition as illustrated in FIG. 1A.

### Example 4- A PCB fabricated with a single lamination cycle

FIG. 21 illustrates a cross-sectional view of an example PCB fabricated with a single lamination cycle according to an embodiment of the present disclosure. As illustrated in FIG. 21, a PCB 2100 includes multiple conductive layers M1, M2, M3, M4, M5, M6, M7, and M8, e.g., 18 µm thick. The PCB 2100 also includes dielectric layers D1, D2, D3, D4, D5, D6 and D7 interleaved with the conductive layers M1, M2, M3, M4, M5, M6, M7, and M8. The dielectric layers D1-D6 may be formed of a generic dielectric material, while the dielectric layer D7 may be formed of an RF-friendly dielectric material. The dielectric layers may also be referred to as cores or core layers. The generic pre-pre-preg and the generic core may be alternately used because the generic pre-preg is easy to bond between two generic core.

In this example, the first dielectric layer D1 between M1 and M2 may be formed of a generic core, e.g., 125 µm thick. The second dielectric layer D2 between M2 and M3 may be formed of a generic pre-preg (cured), e.g., 250 µm thick. The third dielectric layer D3 between M3 and M4 may be formed of a generic core, e.g., 250 µm thick. The fourth dielectric layer D4 between M4 and M5 may be formed of a generic pre-preg (cured), e.g., 250 µm thick. The fifth dielectric layer D5 between M5 and M6 may be formed of a generic core, e.g., 250 µm thick. The sixth dielectric layer D6 between M6 and M7 may be formed of a generic pre-preg (cured), e.g., 125 µm thick.

The seventh dielectric layer D7 between M7 serving as a ground plane and M8 including circuit traces may be formed of an RF-friendly dielectric material, e.g., 125 µm thick. The RF-friendly dielectric layer D7 is more isotropic or uniform than the dielectric layers D1-D6 formed from generic pre-pregs (cured) or generic cores.

The PCB 2100 may also include a top conductive layer 2102A and a bottom conductive layer 2102B. The PCB 2100 may also include through via 2104 having conductive sidewall 2108 and blind vias 2106A and 2106B with conductive sidewall 2110A and 2110B, respectively. The through via 2104 is filled with a dielectric material. The dielectric material may be a generic dielectric material. In some variations, the through via 2104 may be left unfilled. Example 4 illustrates a standard single lamination cycle.

### Example 5- A PCB fabricated by dual-lamination cycles with pre-pregs as outer layers

FIG. 22A illustrates a cross-sectional view of an example inner core of a PCB fabricated with a first lamination cycle in dual-lamination cycles according to an embodiment of the present disclosure. As illustrated in FIG. 22A, an inner core 2200A of a PCB 2202B includes multiple conductive layers M2, M3, M4, M5, M6, and M7. The inner core 2200A also includes dielectric layers D2, D3, D4, D5, and D6 interleaved with the conductive layers M2, M3, M4, M5, M6, and M7. The dielectric layers D2-D6 may be formed of a generic dielectric material.

FIG. 22B illustrates a cross-sectional view of an example PCB including outer layers formed with a second lamination cycle in dual-lamination cycles according to an embodiment of the present disclosure. As illustrated in FIG. 22B, the PCB 2202B includes outer layers added to the top and the bottom of the inner core 2200A in a second lamination cycle. The first dielectric layer D1 between the conductive layers M1 and M2 is formed of a generic pre-preg (cured), while the seventh dielectric layer D7 between the conductive layers M7 and M8 is formed of an RF-friendly pre-preg (cured).

In this example, the second dielectric layer D2 between M2 and M3 may be formed of a generic core, e.g., 250 µm thick. The third dielectric layer D3 between M3 and M4 may be formed of a generic pre-preg (cured), e.g., 250 µm thick. The fourth dielectric layer D4 between M4 and M5 may be formed of a generic core, e.g., 250 µm thick. The fifth dielectric layer D5 between M5 and M6 may be formed of a generic pre-preg (cured), e.g., 250 µm thick. The sixth dielectric layer D6 between M6 and M7 may be formed of a generic core, e.g., 250 µm thick.

The PCB 2200B may also include a top conductive layer 2202A and a bottom conductive layer 2202B. The PCB 2200B may also include buried via 2204 having conductive sidewall 2208 and blind vias 2206A and 2206B with conductive sidewall 2210A and 2210B, respectively. The buried via 2204 and blind vias 2206A and 2206B are filled with a dielectric material, either an RF-friendly or generic dielectric material. In some variations, dielectric layers D1 and D7 are made to fill the vias.

### Example 6- A PCB fabricated by dual-lamination cycles with pre-preg and core combo

FIG. 23 illustrates a cross-sectional view of a PCB fabricated with a first lamination cycle in dual-lamination cycles according to an embodiment of the present disclosure. As illustrated in FIG. 23, a PCB 2300 includes an inner core 2200A which includes multiple conductive layers M2, M3, M4, M5, M6, and M7 interleaved with multiple dielectric layers D2, D3, D4, D5, and D6. The inner core 2200A is formed in a first lamination cycle, as described above. The PCB 2300 also includes outer layers added to the top and the bottom of the inner core 2200A in a second lamination cycle. The first dielectric layer D1 between the conductive layers M1 and M2 is formed of a generic pre-preg (cured). The bottom includes the seventh dielectric layer D7 between the conductive layers M7 and M8, which is a combo of an RF-friendly pre-preg (cured) and an RF-friendly core. The RF-friendly pre-preg, e.g., 62.5 µm thick, is next to the conductive layer M7 to bond to the conductive layer during curing. The RF-friendly core, 62.5 µm thick, includes the conductive layer M8. The RF-friendly core layer D7 as the outer layer may be desirable for radio frequency (RF) and mmWave circuits due to better consistencies than the pre-preg.

The PCB 2300 may also include a top conductive layer 2302A and a bottom conductive layer 2302B. The PCB 2300 may also include buried via 2304 having conductive sidewall 2308 and blind vias 2306A and 2306B with conductive sidewall 2310A and 2310B, respectively.

In some aspects, N is an integer and is equal to or greater than 4.

In some aspects, the shielding structure may include an outer shell having a first segment extending from the first conductive layer to the Nth conductive layer and a second segment extending from the first conductive layer to the (N-1)th conductive layer, wherein the outer shell is coaxial with the signal via.

In some aspects, the second segment of the outer shell is configured to avoid shorting to the first conductive trace.

In some aspects, the shielding structure may include a plurality of ground vias surrounding the signal via.

In some aspects, the plurality of ground vias may include a first subset of the plurality of ground vias extending from the first conductive layer to the Nth conductive layer, and a second subset of the plurality of ground vias extending from the first conductive layer to the (N-1)th conductive layer to prevent the second subset of the plurality of ground vias from shorting to the first conductive trace.

In some aspects, the core may include a plurality of blind vias in the first dielectric layer, and the plurality of blind vias configured for shielding the first conductive trace.

In some aspects, the signals may have an RF frequency ranging from 0 to 90 GHz.

In some aspects, the first dielectric layer between the Nth conductive layer and the (N-1)th conductive layer comprises an RF-friendly dielectric material.

In some aspects, the second dielectric layer between the (N-1)th conductive layer and the (N-2)th conductive layer may be an RF-friendly dielectric material.

In some aspects, the third dielectric layer between the first conductive layer and the (N-2)th conductive layer may be an RF-friendly dielectric material.

In some aspects, the third dielectric layer between the first conductive layer and the (N-2)th conductive layer may be a generic dielectric material.

In some aspects, the dielectric filling material (e.g., via fill) may have a dielectric constant Dk ranging from 2 to 4 and a loss tangent Df less than 0.005. The dielectric filling material may be substantially isotropic after curing.

In some aspects, the pre-preg layer has a material that is not fully cured. The pre-pre-preg layer has no more than one side having a copper foil on the pre-preg layer or without copper foil on the pre-pre-preg layer, such that the pre-preg layer can both flow around features and bond to other materials.

In some aspects, a core layer has a fully cured material, which may have copper foils on both sides.

In some aspects, the signal via may transition the signals from the first conductive trace to the second conductive trace to provide a horizontal-to-horizontal (H2H) transition.

In some aspects, the signal via may transition the signals from the pin to the first conductive trace to the pin to provide a vertical to horizontal (V2H) transition.

In some aspects, the signals may have millimeter (mm) wavelengths.

In some aspects, the core may have a conductive pad connected to the pin on the second side of the laminated core.

Statement 1. A printed circuit board (PCB) core structure for a transition of signals from one side of a PCB to an opposing side of the PCB, the PCB core structure comprising: a laminated core comprising an inner core comprising a plurality of conductive layers (N-1 layers), a first dielectric layer disposed over an (N-1)th conductive layer of the inner core, and an Nth conductive layer over the first dielectric layer; a first conductive trace disposed over the Nth conductive layer on a first side of the laminated core; a signal via extending from a first conductive layer to an Nth conductive layer through the laminated core, the signal via configured to connect the first conductive trace to a pin or a second conductive trace on a second side of the laminated core; a shielding structure surrounding the signal via and partially extending from the first conductive layer to the Nth conductive layer; and a cavity formed by removing a portion of the shielding structure in the Nth conductive layer and filled with a dielectric material, wherein the cavity filled with the dielectric material prevents the first conductive trace from shorting to the shielding structure.

Statement 2. The PCB core structure of statement 1, wherein N is an integer and is equal to or greater than 4.

Statement 3. The PCB core structure of any one of the preceding statements, wherein the shielding structure comprises an outer shell having a first segment extending from the first conductive layer to the Nth conductive layer and a second segment extending from the first conductive layer to the (N-1)th conductive layer, wherein the outer shell is coaxial with the signal via.

Statement 4. The PCB core structure of statement 3, wherein the second segment of the outer shell is configured to avoid shorting to the first conductive trace.

Statement 5. The PCB core structure of statement 1, wherein the shielding structure comprises a plurality of ground vias surrounding the signal via.

Statement 6. The PCB core structure of statement 5, wherein the plurality of ground vias comprises a first subset of the plurality of ground vias extending from the first conductive layer to the Nth conductive layer, and a second subset of the plurality of ground vias extending from the first conductive layer to the (N-1)th conductive layer to prevent the second subset of the plurality of ground vias from shorting to the first conductive trace.

Statement 7. The PCB core structure of any one of the preceding statements, further comprising a plurality of blind vias in the first dielectric layer, and the plurality of blind vias configured for shielding the first conductive trace.

Statement 8. The PCB core structure of any one of the preceding statements, wherein the signals have an RF frequency ranging from 0 to 90 GHz.

Statement 9. The PCB core structure of any one of the preceding statements, wherein the first dielectric layer between the Nth conductive layer and the (N-1)th conductive layer comprises an RF-friendly dielectric material being substantially isotropic and having a dielectric constant Dk ranging from 2.0 to 5.0 and a loss tangent Df less than 0.003.

Statement 10. The PCB core structure of any one of the preceding statements, wherein the second dielectric layer between the (N-1)th conductive layer and another (N-2)th conductive layer comprises a generic dielectric material.

Statement 11. The PCB core structure of any one of the preceding statements, wherein the signal via transitions the signals from the first conductive trace to the second conductive trace to provide a horizontal to horizontal (H2H) transition.

Statement 12. The PCB core structure of any one of the preceding statements, wherein the signal via transitions the signals from the pin to the first conductive trace to the pin to provide a vertical to horizontal (V2H) transition.

Statement 13. The PCB core structure of any one of the preceding statements, wherein the signals have millimeter (mm) wavelengths or frequency content in a range from 0 GHz to 90 GHz or are broadband in nature.

Statement 14. The PCB core structure of any one of the preceding statements, further comprising a conductive pad connected to the pin on the second side of the laminated core.

Statement 15. A method for forming a PCB core structure for transition of signals from one side of a printed circuit board (PCB) to an opposing side of the PCB, the method comprising: providing a laminated core comprising an inner core comprising a plurality of conductive layers (N-1 layers), a first RF-friendly dielectric layer disposed over an (N-1)th conductive layer of the inner core, and an Nth conductive layer over the first RF-friendly dielectric layer; forming a first conductive trace disposed over the Nth conductive layer on a first side of the laminated core; generating a signal via extending from a first conductive layer to an Nth conductive layer through the laminated core, the signal via configured to connect the first conductive trace to a pin or a second conductive trace on a second side of the laminated core; creating a shielding structure surrounding the signal via and partially extending from the first conductive layer to the Nth conductive layer; and forming a cavity by removing a portion of the shielding structure in the Nth conductive layer and filled with a dielectric material, wherein the cavity filled with the dielectric material prevents the first conductive trace from shorting to the shield structure.

Statement 16. The method of statement 15, wherein N is an integer and is equal to or greater than 4.

Statement 17. The method of any one of the preceding statements 15-16, wherein the shielding structure comprises an outer shell having a first segment extending from the first conductive layer to the Nth conductive layer and a second segment extending from the first conductive layer to the (N-1)th conductive layer, wherein the second segment of the outer shell is configured to avoid shorting to the first conductive trace, wherein the outer shell is coaxial with the signal via.

Statement 18. The method of any one of the preceding statements 15-17, wherein the shielding structure comprises a plurality of ground vias surrounding the signal via.

Statement 19. The method of any one of the preceding statements 15-18, wherein the plurality of ground vias comprising a first subset of ground vias extending from the first conductive layer to the Nth conductive layer, and a second subset of the plurality of ground vias extending from the first conductive layer to the (N-1)th conductive layer to prevent the second subset of the plurality of ground vias from shorting to the first conductive trace.

Statement 20. The method of any one of the preceding statements 15-19, further comprising forming a plurality of blind vias in the first dielectric layer, and a plurality of blind vias configured for shielding the first conductive trace.

Any ranges cited herein are inclusive. The terms "substantially" and "about" used throughout this Specification are used to describe and account for small fluctuations. For example, they can refer to less than or equal to ± 5%, such as less than or equal to ± 2%, such as less than or equal to ± 1%, such as less than or equal to ± 0.5%, such as less than or equal to ± 0.2%, such as less than or equal to ± 0.1 %, such as less than or equal to ± 0.05%.

Having described several embodiments, it will be recognized by those skilled in the art that various modifications, alternative constructions, and equivalents may be used without departing from the spirit of the invention. Additionally, a number of well-known processes and elements have not been described in order to avoid unnecessarily obscuring the invention. Accordingly, the above description should not be taken as limiting the scope of the invention.

Those skilled in the art will appreciate that the presently disclosed embodiments teach by way of example and not by limitation. Therefore, the matter contained in the above description or shown in the accompanying drawings should be interpreted as illustrative and not in a limiting sense. The following claims are intended to cover all generic and specific features described herein, as well as all statements of the scope of the method and system, which, as a matter of language, might be the to fall therebetween.

## Claims

1. A printed circuit board (PCB) core structure for a transition of signals from one side of a PCB to an opposing side of the PCB, the PCB core structure comprising:
a laminated core comprising an inner core comprising a plurality of conductive layers (N-1 layers), a first dielectric layer disposed over an (N-1)th conductive layer of the inner core, and an Nth conductive layer over the first dielectric layer;
a first conductive trace disposed over the Nth conductive layer on a first side of the laminated core;
a signal via extending from a first conductive layer to an Nth conductive layer through the laminated core, the signal via configured to connect the first conductive trace to a pin or a second conductive trace on a second side of the laminated core;
a shielding structure surrounding the signal via and partially extending from the first conductive layer to the Nth conductive layer; and
a cavity formed by removing a portion of the shielding structure in the Nth conductive layer and filled with a dielectric material, wherein the cavity filled with the dielectric material prevents the first conductive trace from shorting to the shielding structure.

2. The PCB core structure of claim 1, wherein N is an integer and is equal to or greater than 4.

3. The PCB core structure of any one of the preceding claims, wherein the shielding structure comprises an outer shell having a first segment extending from the first conductive layer to the Nth conductive layer and a second segment extending from the first conductive layer to the (N-1)th conductive layer, wherein the outer shell is coaxial with the signal via, wherein the second segment of the outer shell is configured to avoid shorting to the first conductive trace.

4. The PCB core structure of any one of the preceding claims, wherein the shielding structure comprises a plurality of ground vias surrounding the signal via, wherein the plurality of ground vias comprises a first subset of the plurality of ground vias extending from the first conductive layer to the Nth conductive layer, and a second subset of the plurality of ground vias extending from the first conductive layer to the (N-1)th conductive layer to prevent the second subset of the plurality of ground vias from shorting to the first conductive trace.

5. The PCB core structure of any one of the preceding claims, further comprising a plurality of blind vias in the first dielectric layer, and the plurality of blind vias configured for shielding the first conductive trace.

6. The PCB core structure of any one of the preceding claims, wherein the signals have an RF frequency ranging from 0 to 90 GHz.

7. The PCB core structure of any one of the preceding claims, wherein the first dielectric layer between the Nth conductive layer and the (N-1)th conductive layer comprises an RF-friendly dielectric material being substantially isotropic and having a dielectric constant Dk ranging from 2.0 to 5.0 and a loss tangent Df less than 0.003.

8. The PCB core structure of any one of the preceding claims, wherein the second dielectric layer between the (N-1)th conductive layer and another (N-2)th conductive layer comprises a generic dielectric material.

9. The PCB core structure of any one of the preceding claims, wherein the signal via transitions the signals from the first conductive trace to the second conductive trace to provide a horizontal to horizontal (H2H) transition or wherein the signal via transitions the signals from the pin to the first conductive trace to the pin to provide a vertical to horizontal (V2H) transition.

10. The PCB core structure of any one of the preceding claims, further comprising a conductive pad connected to the pin on the second side of the laminated core.

11. A method for forming a PCB core structure for transition of signals from one side of a printed circuit board (PCB) to an opposing side of the PCB, the method comprising:
providing a laminated core comprising an inner core comprising a plurality of conductive layers (N-1 layers), a first RF-friendly dielectric layer disposed over an (N-1)th conductive layer of the inner core, and an Nth conductive layer over the first RF-friendly dielectric layer;
forming a first conductive trace disposed over the Nth conductive layer on a first side of the laminated core;
generating a signal via extending from a first conductive layer to an Nth conductive layer through the laminated core, the signal via configured to connect the first conductive trace to a pin or a second conductive trace on a second side of the laminated core;
creating a shielding structure surrounding the signal via and partially extending from the first conductive layer to the Nth conductive layer; and
forming a cavity by removing a portion of the shielding structure in the Nth conductive layer and filled with a dielectric material, wherein the cavity filled with the dielectric material prevents the first conductive trace from shorting to the shield structure.

12. The method of claim 11, wherein N is an integer and is equal to or greater than 4.

13. The method of any one of the preceding claims 11-12, wherein the shielding structure comprises an outer shell having a first segment extending from the first conductive layer to the Nth conductive layer and a second segment extending from the first conductive layer to the (N-1)th conductive layer, wherein the second segment of the outer shell is configured to avoid shorting to the first conductive trace, wherein the outer shell is coaxial with the signal via.

14. The method of any one of the preceding claims 11-13, wherein the shielding structure comprises a plurality of ground vias surrounding the signal via, wherein the plurality of ground vias comprising a first subset of ground vias extending from the first conductive layer to the Nth conductive layer, and a second subset of the plurality of ground vias extending from the first conductive layer to the (N-1)th conductive layer to prevent the second subset of the plurality of ground vias from shorting to the first conductive trace.

15. The method of any one of the preceding claims 11-14, further comprising forming a plurality of blind vias in the first dielectric layer, and a plurality of blind vias configured for shielding the first conductive trace.
